# EUROPEAN PATENT APPLICATION

(11) **EP 2 298 959 A1**
(43) Date of publication of application: **23.03.2011**
(21) Application number: 09758432.0
(22) Date of filing: 05.06.2009
(51) Int. Cl.: C23C 16/54, C23C 16/24, H01L 31/04

(54) **FILM FORMATION APPARATUS**

(30) Priority: 06.06.2008 JP 2008149938
(71) Applicant: Ulvac, Inc., Chigasaki-shi Kanagawa 253-8543 (JP)
(72) Inventor: SHIMIZU Yasuo, Chigasaki-shi Kanagawa 253-8543 (JP); OGATA Hideyuki, Chigasaki-shi Kanagawa 253-8543 (JP); MATSUMOTO Koichi, Chigasaki-shi Kanagawa 253-8543 (JP); NOGUCHI Takafumi, Chigasaki-shi Kanagawa 253-8543 (JP); WAKAMORI Jouji, Chigasaki-shi Kanagawa 253-8543 (JP); OKAYAMA Satohiro, Chigasaki-shi Kanagawa 253-8543 (JP); MORIOKA Yawara, Chigasaki-shi Kanagawa 253-8543 (JP); SUGIYAMA Noriyasu, Chigasaki-shi Kanagawa 253-8543 (JP); SHIGETA Takashi, Chigasaki-shi Kanagawa 253-8543 (JP); KURIHARA Hiroyuki, Chigasaki-shi Kanagawa 253-8543 (JP)
(74) Representative: Eisenführ, Speiser & Partner
(86) International application number: PCT/JP2009/060388
(87) International publication number: WO 2009/148165

(57) **Abstract**

A film formation apparatus includes: a film forming chamber (11) in which a desired film is formed on a substrate (W) in a vacuum; a loading-ejecting chamber (13) fixed to the film forming chamber (11) with a first opening-closing section (25) interposed therebetween, being capable of reducing an internal pressure so as to form a vacuum atmosphere; a second opening-closing section (36) provided at a face opposite to the face of the loading-ejecting chamber (13) on which the first opening-closing section (25) is provided; and a carrier (21) holding the substrate (W) so that a film formation face of the substrate (W) is substantially parallel to a direction of gravitational force, wherein the carrier (21) or the substrate (W) passes through the second opening-closing section (36), and is transported to the loading-ejecting chamber (13) and is transported from the loading-ejecting chamber (13); a plurality of carriers (21) is disposed in the loading-ejecting chamber (13) in parallel to each other; the plurality of carriers (21) is transported in parallel between the loading-ejecting chamber (13) and the film forming chamber (11); and a film is simultaneously formed on a plurality of substrates (W) that is held by the plurality of carriers (21) in the film forming chamber (11).

## Description

### BACKGROUND OF THE INVENTION

### Field of the Invention

The present invention relates to a film formation apparatus.

Priority is claimed on Japanese Patent Application No. 2008-149938 filed on June 6, 2008, the contents of which are incorporated herein by reference.

### Background Art

Since materials used for current solar cells are accounted for single crystal Si type and polycrystal Si type materials, there are growing concerns about material shortages or the like of Si.

Thus, demand has recently been increasing for thin-film solar cells formed with a thin-film Si-layer in which the manufacturing costs are low and the risk of material shortages is low.

Moreover, in addition to conventional thin-film solar cells having only an a-Si (amorphous silicon) layer, demand has recently been increasing for tandem-type thin-film solar cells aiming at improvements in conversion efficiency by laminating an a-Si-layer and a µc-Si (microcrystalline silicon) layer.

A plasma-CVD apparatus is often used in a film forming process of a thin-film Si-layer (semiconductor layer) of thin-film solar cells. As the plasma-CVD apparatus, a single-wafer-type PE-CVD (plasma CVD) apparatus, an in-line type PE-CVD apparatus, a batch-type PE-CVD apparatus, and the like are known.

When the conversion efficiency of a thin-film solar cell is taken into consideration, it is necessary to secure a film thickness (approximately 1.5 µm) of approximately five times larger than the a-Si-layer, as the film thickness of the µc-Si-layer of the above-described tandem-type solar cell. Additionally, it is necessary to uniformly form a good microcystal layer in order to obtain the µc-Si-layer, and the film forming process has limitations to formation of a microcystal layer with a high degree of film formation rate. Therefore, for example, it is needed to increase the number of batches processed to improve productivity. That is, an apparatus which can realize film formation processing at a lower film formation rate and at a higher throughput is needed.

Additionally, a CVD apparatus aiming at being able to form a high-quality thin film and lowering manufacturing costs or maintenance costs is proposed (for example, refer to Japanese Unexamined Patent Application, First Publication No. 2005-139524). The CVD apparatus of Japanese Unexamined Patent Application, First Publication No. 2005-139524 includes a substrate (base) delivery/dispensing device, a film forming chamber group capable of storing a plurality of substrates, a transfer chamber, and a chamber transfer device. Moreover, an inlet port of the film forming chamber is provided with an airtight shutter, and an inlet port of a storage chamber of the transfer chamber is always opened. Also, in order to form a film on a substrate, the transfer chamber is transferred to the position of the substrate delivery/dispensing device by the chamber transfer device, and a substrate carrier is transferred to the transfer chamber. Additionally, the transfer chamber and the film forming chamber are joined together by the chamber transfer device, the substrate carrier is transferred to the film forming chamber, and a film is formed on the substrate.

Meanwhile, in the CVD apparatus of Japanese Unexamined Patent Application, First Publication No. 2005-139524, in order to film-form a thin-film Si-layer on a substrate, the transfer chamber is joined to the film forming chamber, the shutter of the film forming chamber is opened after the internal pressure of the transfer chamber is reduced so that the inside of the transfer chamber is brought to a vacuum state, and the substrate carrier is transferred to the film forming chamber from the transfer chamber. Thereafter, the substrate is heated within the film forming chamber, and a thin-film Si-layer is formed on the substrate by a plasma CVD method. After the end of the film forming, the substrate is cooled, and the substrate is conveyed to a processing chamber different from the film forming chamber. Accordingly, although films can be simultaneously formed on a plurality of substrates, the time for performing a number of steps other than the time for forming a film on a substrate is required in order to film-form a thin-film Si-layer on the substrate. Therefore, in order to realize a high throughput, it is necessary to increase the number of CVD apparatuses to be installed. However, when the effects of the apparatus to installation area or costs are taken into consideration, there is a limitation on realizing a high throughput. Additionally, since it is necessary to reduce the internal pressure of the transfer chamber after the transfer chamber is joined to the film forming chamber, leaks may occur from the joining portion, or the time required for pressure reduction increases. Additionally, since the number of transfer chambers is smaller than the number of film forming chambers, the replacement time of a carrier may affect the operating rate of the whole apparatus.

### SUMMARY OF THE INVENTION

The present invention has been made in consideration of the above circumstances, and the object thereof is to provide a film formation apparatus which is excellent in terms of productivity or manufacturing costs, and can realize a high throughput.

A film formation apparatus of a first aspect of the present invention, includes: a film forming chamber in which a desired film is formed on a substrate in a vacuum; a loading-ejecting chamber fixed to the film forming chamber with a first opening-closing section interposed therebetween, being capable of reducing an internal pressure so as to form a vacuum atmosphere; a second opening-closing section provided at a face opposite to the face of the loading-ejecting chamber on which the first opening-closing section is provided; and a carrier holding the substrate so that a film formation face of the substrate is substantially parallel to a direction of gravitational force. Furthermore, in the film formation apparatus of the first aspect of the present invention, the carrier or the substrate passes through the second opening-closing section, and is transported to the loading-ejecting chamber and is transported from the loading-ejecting chamber; a plurality of carriers is disposed in the loading-ejecting chamber in parallel to each other; the plurality of carriers is transported in parallel between the loading-ejecting chamber and the film forming chamber; and a film is simultaneously formed on a plurality of substrates that is held by the plurality of carriers in the film forming chamber.

According to the film formation apparatus having the above-described configuration, a plurality of carriers can be arranged in parallel in the loading-ejecting chamber; a plurality of carriers can be transported to the film forming chamber, and a plurality of carriers can be transported from the film forming chamber; and films can be simultaneously formed on a plurality of substrates held by the plurality of carriers. Therefore, production efficiency can be improved. That is, a high throughput can be realized even when processing at a low film formation rate is performed.

Additionally, the area required for a substrate to move within the apparatus can be reduced by holding the substrate by a carrier so that the film formation face of the substrate and the direction of gravitational force become substantially parallel to each other. For this reason, the apparatus can be miniaturized, and a larger number of apparatuses can be arranged in the same installation area as a conventional technique. Accordingly, the number of substrates on which films can be simultaneously formed can be increased, and productivity can be improved. Additionally, when a film is formed in a state where a substrate is erected in the vertical direction so that the film formation face of the substrate becomes substantially parallel to the direction of gravitational force, particles generated when a film is formed can be kept from being deposited on the film formation face of the substrate. Accordingly, a high-quality semiconductor layer can be film-formed on the substrate.

A film formation apparatus of a second aspect of the present invention, includes: a film forming chamber in which a desired film is formed on a substrate in a vacuum; a loading-ejecting chamber fixed to the film forming chamber with a first opening-closing section interposed therebetween, being capable of reducing an internal pressure so as to form a vacuum atmosphere; and a substrate-replacement chamber fixed to the loading-ejecting chamber with a second opening-closing section interposed therebetween, attaching the substrate to a carrier and detaching the substrate from the carrier, the carrier is capable of holding the substrate. Furthermore, in the film formation apparatus of the second aspect of the present invention, the carrier holds the substrate so that a film formation face of the substrate is substantially parallel to a direction of gravitational force; a plurality of carriers is disposed in the substrate-replacement chamber in parallel to each other; the plurality of carriers is transported in parallel between the substrate-replacement chamber and the loading-ejecting chamber; the plurality of carriers is transported in parallel between the loading-ejecting chamber and the film forming chamber; and a film is simultaneously formed on a plurality of substrates that is held by the plurality of carriers in the film forming chamber.

According to the film formation apparatus having the above-described configuration, a plurality of carriers can be arranged in parallel in the substrate-replacement chamber and the loading-ejecting chamber; a plurality of carriers can be transported to the film forming chamber, and a plurality of carriers can be transported from the film forming chamber; and films can be simultaneously formed on a plurality of substrates held by the plurality of carriers. Therefore, production efficiency can be improved. That is, a high throughput can be realized even when processing at a low film formation rate is performed.

Additionally, the area required for a substrate to move within the apparatus can be reduced by holding the substrate by a carrier so that the film formation face of the substrate and the direction of gravitational force become substantially parallel to each other. Therefore, the apparatus can be miniaturized, and a larger number of apparatuses can be arranged in the same installation area as a conventional technique. Accordingly, the number of substrates on which films can be simultaneously formed can be increased, and productivity can be improved. Additionally, when a film is formed in a state where a substrate is erected in the vertical direction so that the film formation face of the substrate becomes substantially parallel to the direction of gravitational force, particles generated when a film is formed can be kept from being deposited on the film formation face of the substrate. Accordingly, a high-quality semiconductor layer can be film-formed on the substrate.

It is preferable that the film formation apparatus of the second aspect of the present invention further include: a plurality of process modules having a set of the substrate-replacement chamber, the loading-ejecting chamber, and the film forming chamber; and a drive mechanism being common in a plurality of substrate-replacement chambers, and transporting the substrate to the substrate-replacement chambers or transporting the substrate from the substrate-replacement chambers.

According to the film formation apparatus having the above-described configuration, the number of substrates on which films can be simultaneously formed can be further increased by arranging a plurality of process modules. Therefore, even when a film is formed on a substrate at a low rate, a high throughput can be realized. At this time, since the drive mechanism performs the transfer of a substrate between the substrate-replacement chamber and a substrate storage holder, the production efficiency can be further improved. Additionally, since the apparatus is integrated into the process module, the installation time (building time of a manufacturing line) of the apparatus when the manufacturing line is built in a factory or the like can be shortened. Moreover, when maintenance of the film forming chamber is performed, it is possible to perform the maintenance on each process module in turn, and it becomes unnecessary to stop the whole manufacturing line. Accordingly, a decrease in production efficiency during maintenance can be suppressed to a minimum.

In the film formation apparatus of the second aspect of the present invention, it is preferable that the process modules be arranged in parallel to each other; and the drive mechanism have a moving section.

According to the film formation apparatus having the above-described configuration, a plurality of process modules is arranged in parallel. Thus, the number of substrates on which films can be simultaneously formed can be further increased. Therefore, a high throughput can be realized even when a film is formed on the substrate at a low rate. At this time, since the drive mechanism which performs the transfer of a substrate between the substrate-replacement chamber and the substrate storage holder is moved by the moving section, one drive mechanism can be shared by a plurality of modules, and a cost reduction can be achieved. Additionally, since the apparatus is integrated into the process module, the installation time (building time of a manufacturing line) of the apparatus when the manufacturing line is built in a factory or the like can be shortened. Moreover, when maintenance of the film forming chamber is performed, it is possible to perform the maintenance on each process module, and it becomes unnecessary to stop the whole manufacturing line. Accordingly, a decrease in production efficiency during maintenance can be suppressed to a minimum.

In the film formation apparatus of the second aspect of the present invention, it is preferable that the process modules be disposed so as to radially extend from the drive mechanism.

According to the film formation apparatus having the above-described configuration, transfer of a substrate can be performed with respect to a plurality of process modules without moving the drive mechanism using the moving section. Accordingly, the operating time of the drive mechanism can be shortened, and the tact time can be shortened.

It is preferable that the film formation apparatus of the first and second aspects of the present invention further include: a plurality of process modules in which one film forming chamber is consecutively connected to one loading-ejecting chamber. In the film formation apparatus, the process modules are disposed in parallel to each other.

According to the film formation apparatus having the above-described configuration, the number of substrates on which films can be simultaneously formed can be further increased by a plurality of process modules arranged in parallel. Therefore, a high throughput can be realized even when a film is formed on the substrate at a low rate. At this time, the drive mechanism which performs the transfer of a substrate between the substrate-replacement chamber and the substrate storage holder is shared by a plurality of modules, so that cost reduction can be achieved. Additionally, since the apparatus is integrated into the process module, the installation time (building time of a manufacturing line) of the apparatus when the manufacturing line is built in a factory or the like can be shortened. Moreover, when maintenance of the film forming chamber is performed, it is possible to perform the maintenance on each process module in turn, and it becomes unnecessary to stop the whole manufacturing line. Accordingly, a decrease in production efficiency during maintenance can be suppressed to a minimum.

It is preferable that the film formation apparatus of the first and second aspects of the present invention further include: a process module in which each of a plurality of film forming chambers is consecutively connected to one loading-ejecting chamber, and in which the film forming chambers are disposed in parallel to each other.

According to the film formation apparatus having the above-described configuration, a substrate attached to a carrier within the loading-ejecting chamber can be moved. For this reason, when different film forming materials are respectively supplied to a plurality of film forming chambers a substrate is conveyed through the loading-ejecting chamber between a plurality of film forming chambers, and different kinds of film forming materials are sequentially laminated on the substrate. Through this, a film can be efficiently formed on a substrate which has a multilayer structure.

It is preferable that the film formation apparatus of the first and second aspects of the present invention further include: process modules in which one film forming chamber is consecutively connected to one loading-ejecting chamber; and a drive mechanism transporting the substrate to the film forming chamber and transporting the substrate from the film forming chamber. In the film formation apparatus, the process modules are disposed so as to radially extend from the drive mechanism.

According to the film formation apparatus having the above-described configuration, the number of substrates on which films can be simultaneously formed can be further increased by arranging a plurality of process modules. Therefore, even when a film is formed on a substrate at a low rate, a high throughput can be realized. At this time, since a drive mechanism performs transfer of a substrate between the substrate-replacement chamber and the substrate storage holder, production efficiency can be further improved. Additionally, since the apparatus is integrated into the process module, the installation time (building time of a manufacturing line) of the apparatus when the manufacturing line is built in a factory or the like can be shortened. Moreover, when maintenance of the film forming chamber is performed, it is possible to perform the maintenance on each process module in turn, and it becomes unnecessary to stop the whole manufacturing line. Accordingly, a decrease in production efficiency during maintenance can be suppressed to a minimum.

Additionally, since the process modules are installed so as to extend radially from the drive mechanism, transfer of a substrate can be performed with respect to a plurality of process modules without moving the drive mechanism using the moving section. That is, the operating time of the drive mechanism can be shortened, and the tact time can be shortened.

In the film formation apparatus of the first and second aspects of the present invention, it is preferable that the carrier be capable of holding a plurality of substrates.

According to the film formation apparatus having the above-described configuration, since films can be simultaneously formed on a plurality of substrates in one carrier, the productivity can be further improved.

In the film formation apparatus of the first and second aspects of the present invention, it is preferable that one or two carriers be capable of holding the substrate so that film formation faces of two substrates face each other.

According to the film formation apparatus having the above-described configuration, films can be simultaneously formed on two substrates by supplying a film forming material from between the two substrates. Accordingly, the productivity can be improved.

It is preferable that the film formation apparatus of the first and second aspects of the present invention further include: a transfer section storing the substrate, and being capable of transferring the substrate outside of the film formation apparatus.

According to the film formation apparatus having the above-described configuration, by using the transfer section, a substrate can be efficiently conveyed to the outside of the film formation apparatus, for example, apparatuses in which processing processes are performed other than the film formation processing. Therefore, the productivity can be improved.

In the film formation apparatus of the first and second aspects of the present invention, it is preferable that the film forming chamber have a film forming section that forms microcrystalline silicon on the substrate using a CVD method.

According to the film formation apparatus having the above-described configuration, microcrystalline silicon can be simultaneously film-formed on a plurality of substrates. Therefore, a high throughput can be realized even when film formation processing of the microcrystalline silicon, which is processing at a low film formation rate, is performed.

In the film formation apparatus of the first and second aspects of the present invention, it is preferable that the loading-ejecting chamber be capable of simultaneously storing a first carrier in which a pre-transported substrate to be transported to the film forming chamber is held, and a second carrier in which a post-transported substrate that has been transported from the film forming chamber is held.

According to the film formation apparatus having the above-described configuration, the first carrier in which a pre-film-formation-processed substrate which is to be transported to the film forming chamber is held, and the second carrier in which a post-film-formation-processed substrate which has been transported from the film forming chamber is held can be simultaneously stored within the loading-ejecting chamber, the number of processes of switching the atmosphere in the loading-ejecting chamber to a vacuum atmosphere or air atmosphere can be reduced. Accordingly, the productivity can be improved. Moreover, when the pre-film-formation-processed substrate and the post-film-formation-processed substrate are simultaneously stored in the loading-ejecting chamber, the heat accumulated in the post-film-formation-processed substrate is transferred to the pre-film-formation-processed substrate, whereby heat exchange is performed. That is, a heating process which is usually performed after the pre-film-formation-processed substrate is stored in the film forming chamber, and a cooling process which is usually performed before the post-film-formation-processed substrate is transported from the loading-ejecting chamber can be omitted. As a result, the productivity can be improved, and manufacturing costs can be reduced because facilities used for conventional heating and cooling processes can be eliminated.

In the film formation apparatus of the first and second aspects of the present invention, it is preferable that the film forming chamber have a plurality of electrode units. In the film formation apparatus, the electrode units includes: a cathode unit having cathodes to which a voltage is applied, the cathodes being disposed at both sides of the cathode unit; and a pair of anode units having anode that separately face the cathodes disposed at both sides of the cathode unit. In the film formation apparatus, the carrier is capable of holding the substrate so that the substrate faces the cathodes, and is capable of inserting the substrate between the cathodes and the anode.

According to the film formation apparatus having the above-described configuration, since a substrate can be arranged on both sides of one cathode unit, films can be simultaneously formed on two substrates by one electrode unit. Accordingly, the productivity can be improved.

In the film formation apparatus of the first and second aspects of the present invention, it is preferable that the electrode units be able to be drawn from the film forming chamber or able to be inserted to the film forming chamber.

According to the film formation apparatus having the above-described configuration, the electrode unit having the cathode and the anodes can be easily separated from the film forming chamber. For this reason, maintenance work can be performed on the electrode unit as a single body, and it is possible to secure a large work space. Hence, it is possible to reduce the burden of the maintenance work.

Additionally, with the electrode unit as a single body separated from the film forming chamber, it is possible to adjust the distance between the respective electrodes, or for example, it is possible to connect a dummy load to each electrode to adjust the impedances of the respective electrodes. For this reason, various adjustments required to operate the apparatus for manufacturing a thin-film solar cell can be performed off-line.

In the film formation apparatus of the first and second aspects of the present invention, it is preferable that the electrode unit have a drive unit changing a distance between the cathodes and the anode.

According to the film formation apparatus having the above-described configuration, the anode moves in the direction in which the anode comes close to or separates from the cathode unit, the gap between the anode and the cathode unit can be set to be large when a substrate enters and exits the film forming chamber. Meanwhile, when a film is formed on the film formation face of a substrate, the gap between the anode and the cathode unit can be set to be small. As a result, the gap between the substrate and the cathode unit can be set to be small, specifically, approximately 5 mm. For this reason, it is possible to facilitate entrance and exit of a substrate with respect to the film forming chamber while improving the quality of a film to be formed, and it is possible to improve productivity.

Additionally, when the substrate enters and exits the film forming chamber, it is possible to prevent the substrate from contacting with and being damaged by the anode or the cathode unit.

Moreover, the cathode unit of which the movement is comparatively difficult can be arranged between two substrates, that is, between two substrates which are arranged so that the film formation faces thereof face each other. Additionally, the anode of which the movement is easy can be arranged outside two substrates, that is, outside two substrates which are arranged so that the film formation faces thereof face each other. Also, since it is possible to move the anode using a drive unit, the distance between a substrate and the cathode unit is controlled. For this reason, as compared to a case where the cathode unit is moved, complexity of the apparatus for manufacturing a thin-film solar cell can be suppressed, and manufacturing costs can be reduced.

According to the present invention, a plurality of carriers can be arranged in parallel in the loading-ejecting chamber; a plurality of carriers can be transported to the film forming chamber, and a plurality of carriers can be transported from the film forming chamber; and films can be simultaneously formed on a plurality of substrates held by the plurality of carriers. Therefore, production efficiency can be improved. That is, a high throughput can be realized even when processing at a low film formation rate is performed.

Additionally, the area required for a substrate to move within the apparatus can be reduced by holding the substrate by a carrier so that the film formation face of the substrate and the direction of gravitational force become substantially parallel to each other. Therefore, the apparatus can be miniaturized, and a larger number of apparatuses can be arranged in the same installation area as the conventional technique. Accordingly, the number of substrates on which films can be simultaneously formed can be increased, and productivity can be improved. Additionally, when a film is formed in a state where a substrate is erected in the vertical direction so that the film formation face of the substrate becomes substantially parallel to the direction of gravitational force, particles generated when a film is formed can be kept from being deposited on the film formation face of the substrate. Accordingly, a high-quality semiconductor layer can be film-formed on the substrate.

### BRIEF DESCRIPTION OF THE DRAWINGS

FIG. 1 is a schematic sectional view showing a thin-film solar cell in an embodiment of the present invention.
FIG. 2 is a schematic configuration view showing a thin-film solar cell manufacturing apparatus in the embodiment of the present invention.
FIG. 3A is a perspective view showing a film forming chamber in the embodiment of the present invention.
FIG. 3B is the perspective view when the film forming chamber in the embodiment of the present invention is seen from a different angle.
FIG. 3C is a side view showing the film forming chamber in the embodiment of the present invention.
FIG. 4A is a perspective view showing an electrode unit in the embodiment of the present invention.
FIG. 4B is the perspective view when the electrode unit in the embodiment of the present invention is seen from a different angle.
FIG. 4C is an exploded perspective view showing a part of the electrode unit in the embodiment of the present invention.
FIG. 4D is a sectional view showing a part of a cathode unit and anode unit of the electrode unit in the embodiment of the present invention,
FIG. 5A is a perspective view showing a loading-ejecting chamber in the embodiment of the present invention.
FIG. 5B is a perspective view showing the loading-ejecting chamber in the embodiment of the present invention is seen from a different angle.
FIG. 6 is a schematic configuration view showing a push-pull mechanism in the embodiment of the present invention.
FIG. 7A is a perspective view showing a schematic configuration of a substrate-replacement chamber in the embodiment of the present invention.
FIG. 7B is a front view showing a schematic configuration of the substrate-replacement chamber in the embodiment of the present invention.
FIG. 8 is a perspective view showing a substrate storage holder in the embodiment of the present invention.
FIG. 9 is a perspective view showing a carrier in the embodiment of the present invention.
FIG. 10 is an explanatory view (1) showing a process of a method for manufacturing a thin-film cell in the embodiment of the present invention.
FIG. 11 is an explanatory view (2) showing a process of the method for manufacturing a thin-film cell in the embodiment of the present invention.
FIG. 12 is an explanatory view (3) showing a process of the method for manufacturing a thin-film cell in the embodiment of the present invention.
FIG. 13 is an explanatory view (4) showing a process of the method for manufacturing a thin-film cell in the embodiment of the present invention.
FIG. 14 is an explanatory view (5) showing a process of the method for manufacturing a thin-film cell in the embodiment of the present invention.
FIG. 15A is an explanatory view showing the operation of the push-pull mechanism in the embodiment of the present invention.
FIG. 15B is an explanatory view showing the operation of the push-pull mechanism in the embodiment of the present invention.
FIG. 16 is an explanatory view (6) showing a process of the method for manufacturing a thin-film cell in the embodiment of the present invention.
FIG. 17 is an explanatory view (7) showing a process of the method for manufacturing a thin-film cell in the embodiment of the present invention.
FIG. 18 is an explanatory view (8) showing a process of the method for manufacturing a thin-film cell in the embodiment of the present invention, and is a sectional view showing a schematic configuration when substrates are inserted into the electrode unit.
FIG. 19 is an explanatory view (9) showing a process of the method for manufacturing a thin-film cell in the embodiment of the present invention.
FIG. 20 is an explanatory view (10) showing a process of the method for manufacturing a thin-film cell in the embodiment of the present invention.
FIG. 21 is an explanatory view (11) showing a process of the method for manufacturing a thin-film cell in the embodiment of the present invention, and a sectional view showing a configuration in which substrates are partially set on the electrode unit.
FIG. 22 is an explanatory view (12) showing a process of the method for manufacturing a thin-film cell in the embodiment of the present invention.
FIG. 23 is an explanatory view (13) showing a process of the method for manufacturing a thin-film cell in the embodiment of the present invention.
FIG. 24 is an explanatory view (14) showing a process of the method for manufacturing a thin-film cell in the embodiment of the present invention.
FIG. 25 is an explanatory view (15) showing a process of the method for manufacturing a thin-film cell in the embodiment of the present invention.
FIG. 26 is a schematic configuration view showing a first modified example of the thin-film solar cell manufacturing apparatus in the embodiment of the present invention.
FIG. 27 is a schematic configuration view showing a second modified example of the thin-film solar cell manufacturing apparatus in the embodiment of the present invention.
FIG. 28 is a schematic configuration view showing a third modified example of the thin-film solar cell manufacturing apparatus in the embodiment of the present invention.

### DESCRIPTION OF THE PREFERRED EMBODIMENTS

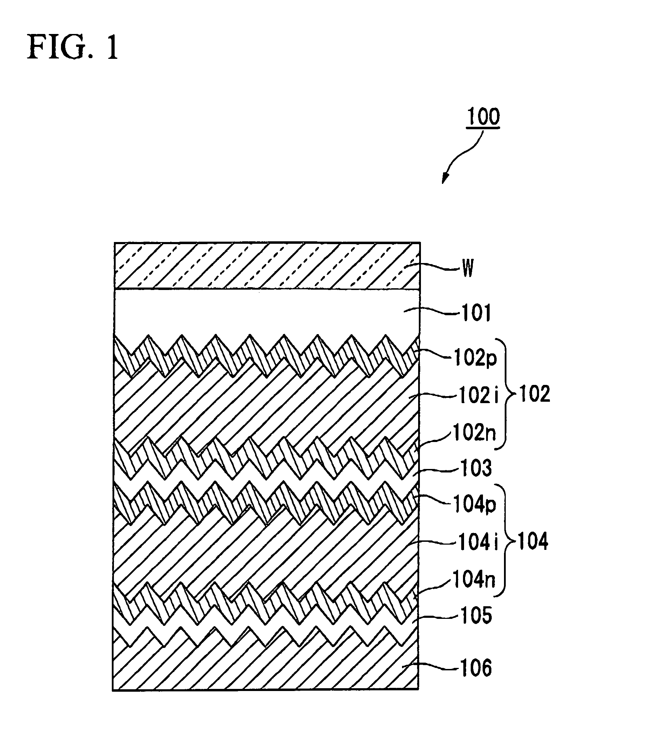

A thin-film solar cell manufacturing apparatus (film formation apparatus) related to an embodiment of the present invention will be described with reference to FIGS. 1 to 28.

### (Thin-film Solar Cell)

FIG. 1 is a schematic sectional view of a thin-film solar cell 100 manufactured by a thin-film solar cell manufacturing apparatus of the present invention.

As shown in FIG. 1, the thin-film solar cell 100 is configured such that a substrate W which constitutes the surface of the solar cell and is made of glass; a top electrode 101 made of a transparent-electroconductive film provided on the substrate W; a top cell 102 made of amorphous silicon; an intermediate electrode 103 made of a transparent-electroconductive film provided between the top cell 102 and a bottom cell 104 which will be described later; the bottom cell 104 made of microcrystalline silicon; a buffer layer 105 made of a transparent-electroconductive film; and a back electrode 106 made of a metal film are stacked in layers.

That is, the thin-film solar cell 100 is an a-Si/microcrystal Si tandem-type solar cell.

In the thin-film solar cell 100 having such a tandem structure, power generation efficiency can be improved by absorbing short-wavelength light by the top cell 102 and absorbing long-wavelength light by the bottom cell 104.

A three-layer structure of a p-layer (102p), i-layer (102i), and n-layer (102n) of the top cell 102 is formed from amorphous silicon.

Additionally, a three-layer structure of a p-layer (104p), i-layer (104i), and n-layer (104n) of the bottom cell 104 is made of microcrystalline silicon.

In the thin-film solar cell 100 having such a configuration, when an energy particle called a photon in sunlight strikes the i-layer, an electron and a positive hole are generated by a photovoltaic effect, the electron moves toward the n-layer and the positive hole moves toward the p-layer.

Light energy can be converted into electrical energy by taking out the electron/positive hole generated by the photovoltaic effect of the top electrode 101 and the back electrode 106.

Additionally, the intermediate electrode 103 is provided between the top cell 102 and the bottom cell 104, whereby a part of the light which passes through the top cell 102 and reaches the bottom cell 104 is reflected by the intermediate electrode 103 and enters the top cell 102 again. Therefore, the sensitivity of the cell improves, and the power generation efficiency improves.

Additionally, the sunlight which has entered the substrate W side passes through the respective layers, and is then reflected by the back electrode 106.

In the thin-film solar cell 100, a texture structure is adopted, which is formed in order to improve the conversion efficiency of light energy, in order to obtain a prismatic effect which extends the optical path of the sunlight which has entered the top electrode 101, and in order to obtain the confinement effect of light.

### (Thin-film Solar Cell Manufacturing Apparatus)

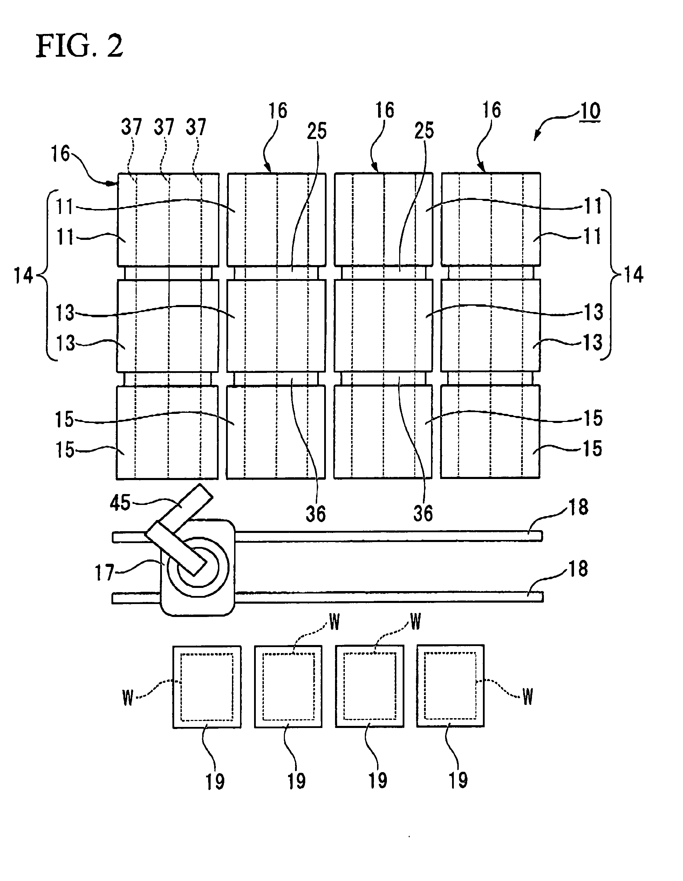

FIG. 2 is a schematic configuration view of a thin-film solar cell manufacturing apparatus that is a film formation apparatus of the present invention.

As shown in FIG. 2, the thin-film solar cell manufacturing apparatus 10 includes film forming chambers 11, loading-ejecting chambers 13, substrate-replacement chambers 15, a substrate replacement robot (drive mechanism) 17, and substrate storage holders 19 (transfer section).

The film forming chambers 11 simultaneously film-form bottom cells 104 (semiconductor layers) made of microcrystalline silicon on a plurality of substrates W by a CVD method.

The loading-ejecting chambers 13 simultaneously store both pre-processed substrates W1 which are to be transported to the film forming chambers 11 and post-processed substrates W2 which have been transported from the film forming chambers 11.

In the following description, the "pre-processed substrate" means a substrate before film formation processing, and the "post-processed substrate" means a substrate after film formation processing.

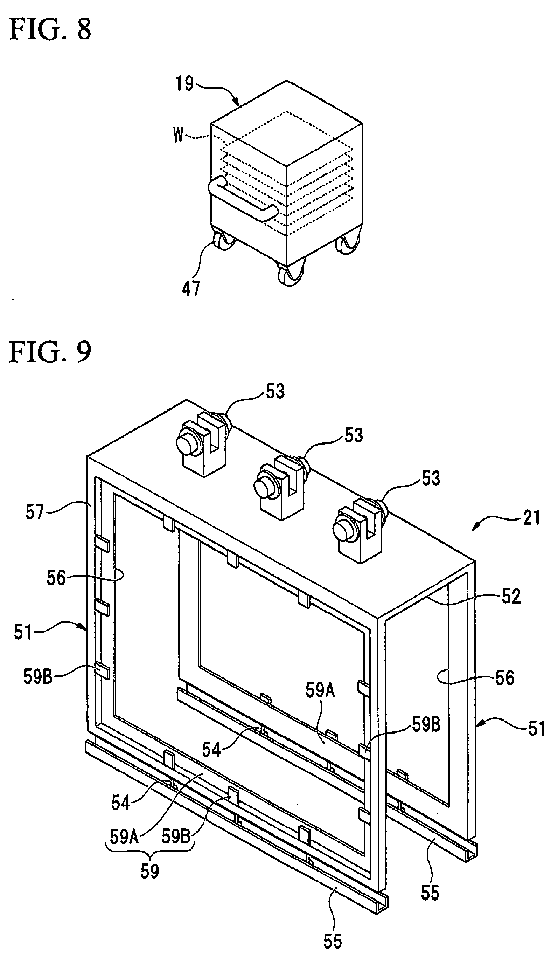

In each substrate-replacement chamber 15, the pre-processed substrate W 1 is attached to a carrier 21 (refer to FIG. 9), or the post-processed substrate W2 is detached from the carrier 21.

The substrate replacement robot 17 attaches a substrate W to the carrier 21, or removes the substrate from the carrier 21.

Each substrate storage holder 19 is used when substrates W are conveyed to a separate processing chamber which is different in the thin-film solar cell manufacturing apparatus 10, and stores the substrates W.

In addition, in the thin-film solar cell manufacturing apparatus 10 of the embodiment, four substrate film formation lines 16 each including a film forming chamber 11, a loading-ejecting chamber 13, and a substrate-replacement chamber 15 are provided.

A moving section is provided at the substrate replacement robot 17, the moving section allowing the substrate replacement robot 17 to move on rails 18 laid on a floor surface. With this configuration, the substrate replacement robot 17 moves on the rails 18, a transfer process of the substrates W to all the substrate film formation lines 16 is performed by one substrate replacement robot 17. In addition, the rails 18 extend in a direction (direction orthogonal to substrate film formation lines 16) in which a plurality of substrate film formation modules 14 is arrayed. The substrate film formation modules 14 is configured so that one film forming chamber 11 is consecutively connected to one loading-ejecting chamber 13 as shown in FIG. 2. Due to driving the moving section, the substrate replacement robot 17 moves along the extending direction of the rails 18.

Moreover, a substrate film formation module 14 is configured by integrating the film forming chamber 11 and the loading-ejecting chamber 13, and has a size such that the module can be loaded into an autotruck for transportation.

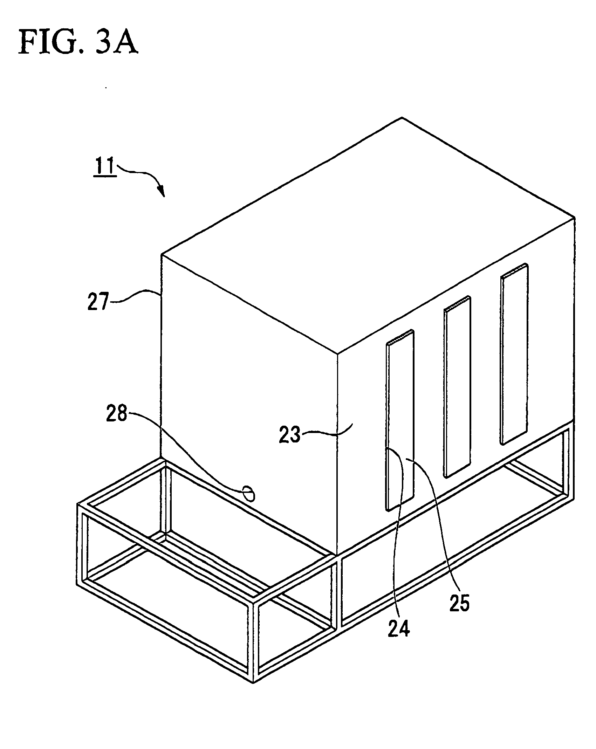

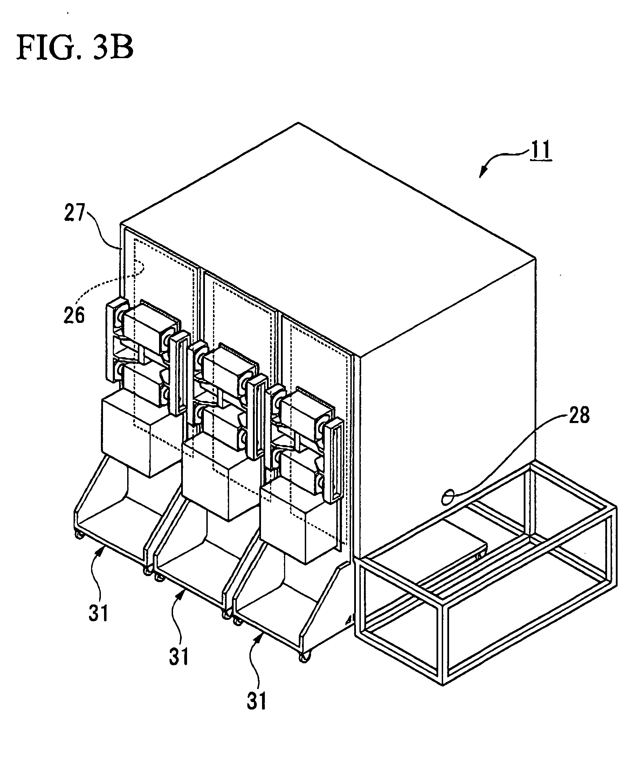

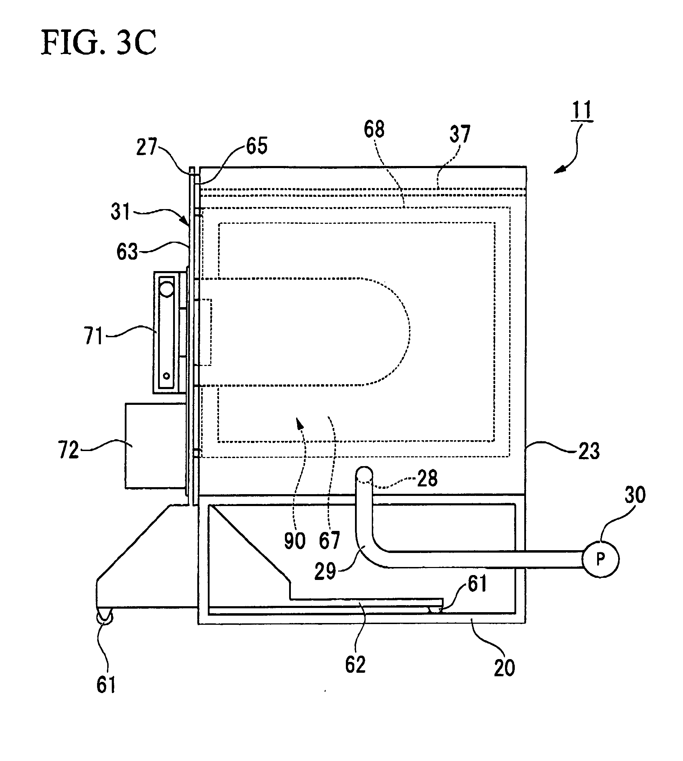

FIGS. 3A to 3C are schematic configuration views of the film forming chamber 11. FIG. 3A is a perspective view, FIG. 3B is a perspective view as seen from an angle different from FIG. 3A, and FIG. 3C is a side view.

As shown in FIGS. 3A to 3C, the film forming chamber 11 is formed in the shape of a box. A lateral surface 23 of the film forming chamber 11 connected to the loading-ejecting chamber 13 is formed with three carrier transfer inlet ports 24 which allow the carrier 21 on which the substrates W are mounted to pass therethrough. In addition, the carrier transfer inlet ports 24 are provided with shutters 25 (first opening-closing section) which open and close the carrier transfer inlet ports 24. When a shutter 25 is closed, the carrier transfer inlet port 24 is closed securing airtightness. Three electrode units 31 (film forming section) for forming films on the substrates W are attached to a lateral surface 27 opposite to the lateral surface 23. The electrode units 31 are configured to be attachable to and detachable from the film forming chamber 11. Additionally, a vacuuming pipe 29 for reducing the pressure of the film forming chamber 11 is connected to a lateral lower portion 28 of the film forming chamber 11 so that the film forming chamber has a vacuum atmosphere, and a vacuum pump 30 is connected to the vacuuming pipe 29.

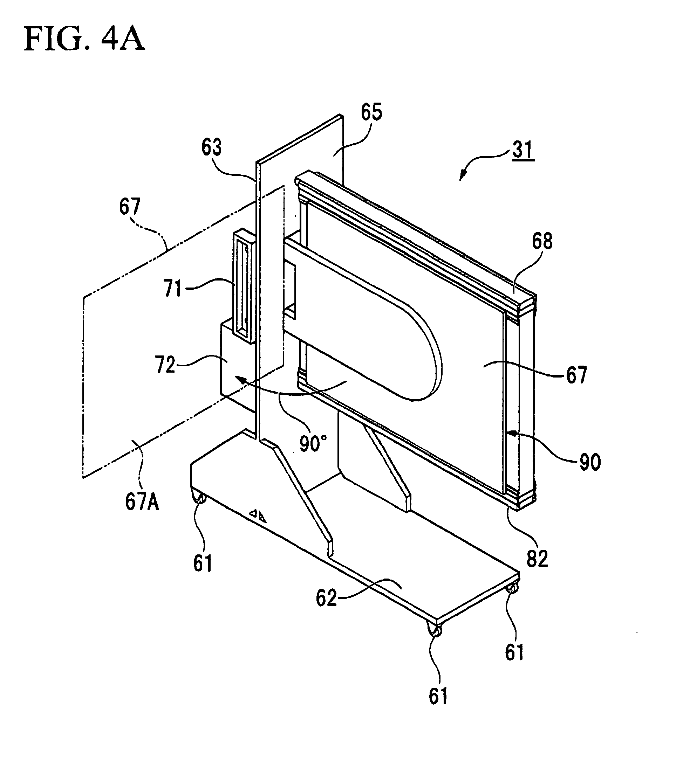

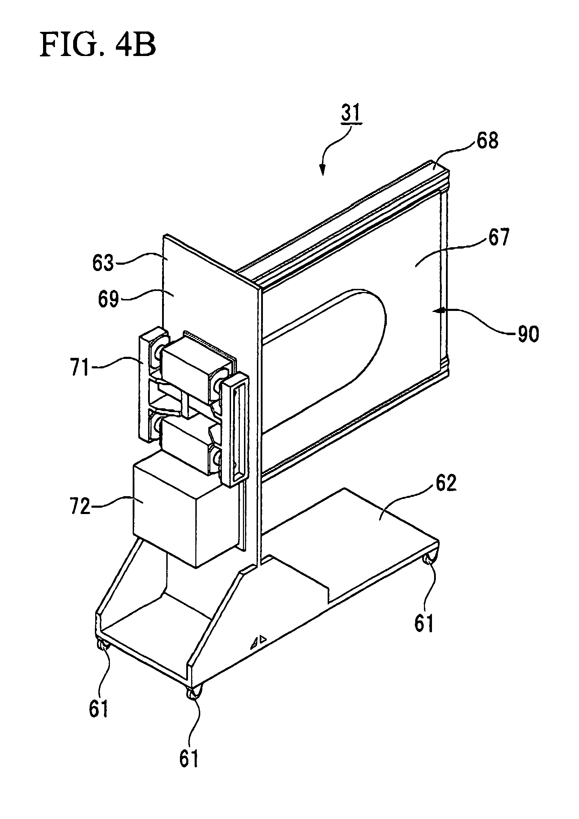

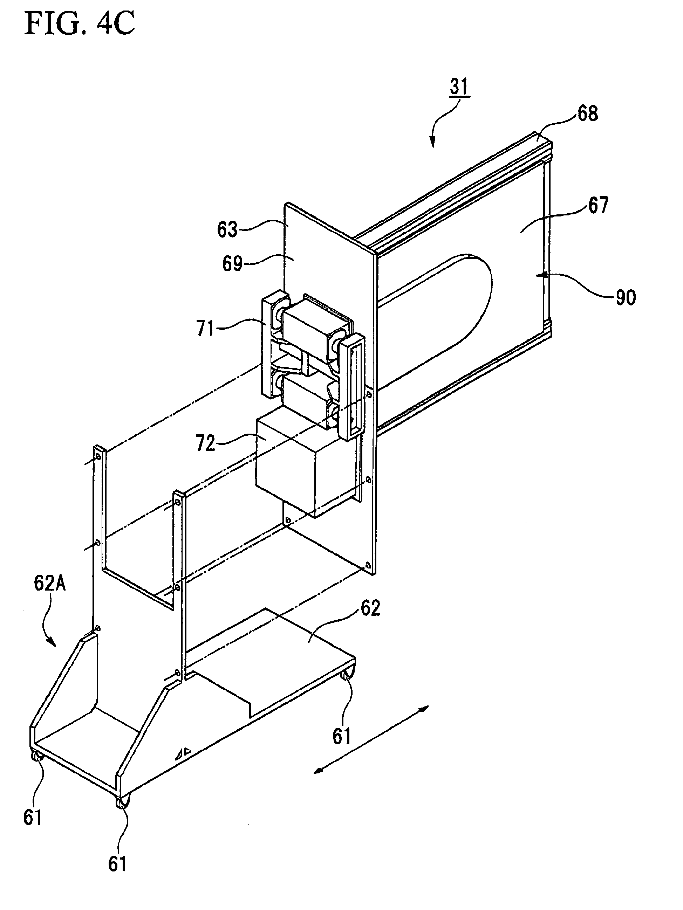

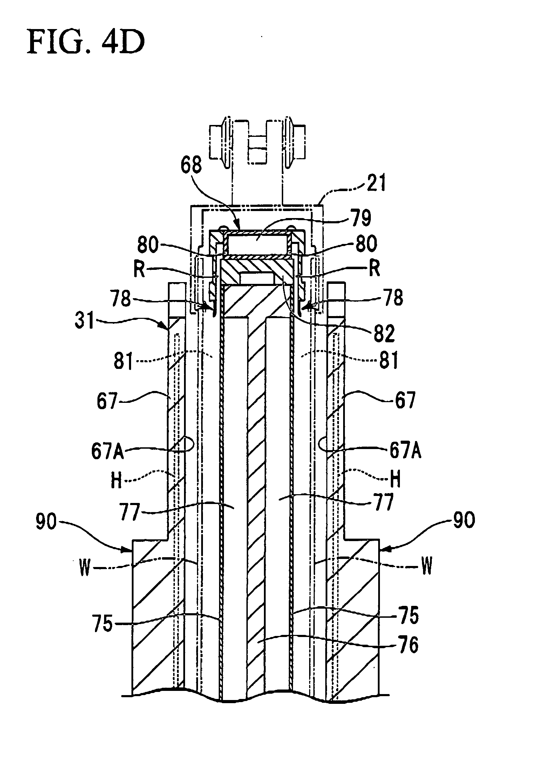

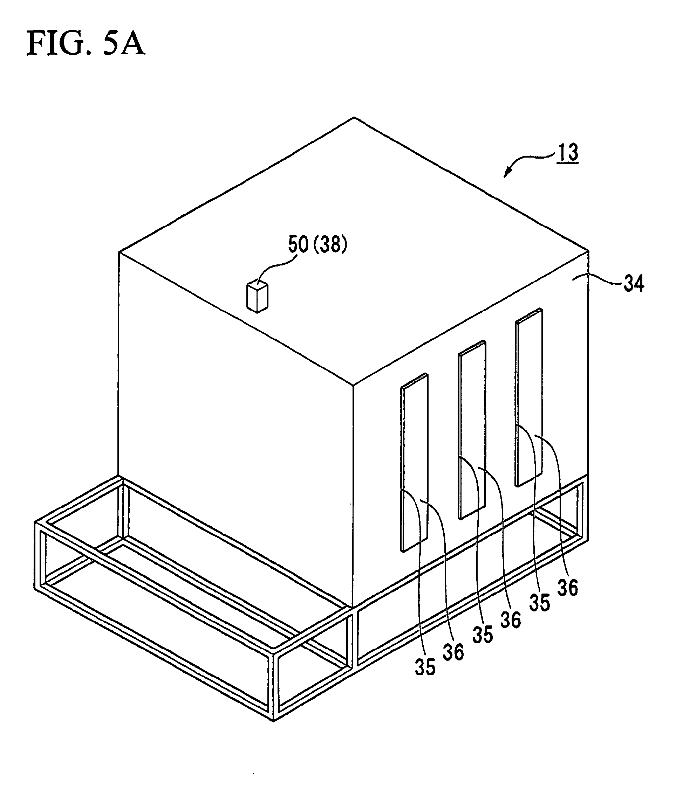

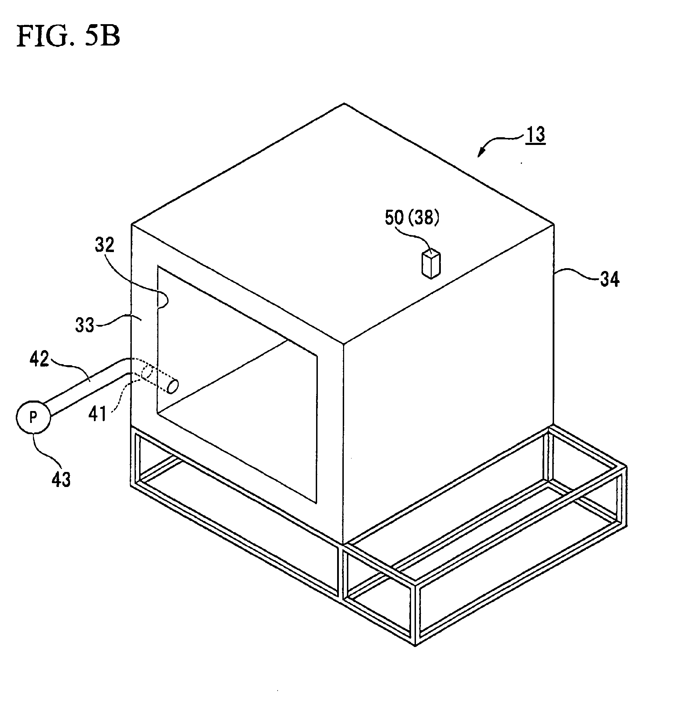

FIGS. 4A to 4D are schematic configuration views of the electrode unit 31. FIG. 4A is a perspective view, FIG. 4B is a perspective view as seen from an angle different from FIG. 4A, FIG. 4C is a perspective view showing a modified example of the electrode unit 31, and FIG. 4D is a sectional view partially showing a cathode unit and an anode unit. Additionally, FIG. 5 is a plan view of a cathode. The electrode units 31 are attachable to and detachable from three openings 26 formed in the lateral surface 27 of the film forming chamber 11 (refer to FIG. 3B). One of a plurality of wheels 61 is provided at each of the four corners of the lower portion, and the electrode units 31 are movable on the floor surface. On a bottom plate portion 62 to which the wheels 61 are attached, a side plate portion 63 is erected in the vertical direction. The side plate portion 63 has a size such that the side plate portion blocks the opening 26 of the lateral surface 27 of the film forming chamber 11. As shown in the modified example of FIG. 4C, the bottom plate portion 62 with the wheels 61 may be a truck 62A which can be separated from and connected to the electrode unit 31. In this case, the truck 62A can be separated from the electrode unit 31 after the electrode unit 31 is connected to the film forming chamber 11. Therefore, the respective electrode units 31 can be transferred by commonly-used truck 62A, and a plurality of trucks is not used.

The side plate portion 63 forms a part of a wall surface of the film forming chamber 11.

One surface (surface which faces the inside of the film forming chamber 11; first surface) 65 of the side plate portion 63 is provided with anode units 90 and a cathode unit 68 which are located on both surfaces of the substrate W when a film is formed. The electrode unit 31 of the embodiment includes a pair of anode units 90 arranged so as to be separated from each other at both ends of the cathode unit 68 with the cathode unit 68 therebetween. In the electrode unit 31, films can be simultaneously formed on two substrates W, using one electrode unit 31. Accordingly, the respective substrates W during film formation processing are arranged on both sides of the cathode unit 68 so as to become substantially parallel to a direction of gravitational force (vertical direction), and so as to face the cathode unit 68. Two anode units 90 are arranged outside respective substrates W in the thickness direction in a state where each of the anodes face the substrates W.

The anode unit 90 is constituted of a plate-like anode 67 and a heater H built in the anode 67.

Additionally, a drive unit 71 for driving the anode units 90, and a matching box 72 for feeding electric power to a cathode intermediate member 76 of the cathode unit 68 when a film is formed are attached to the other surface 69 (second surface) of the side plate portion 63. Moreover, the side plate portion 63 is formed with a connecting portion for piping (not shown) which supplies film forming gas to the cathode unit 68.

A heater H is built in each anode unit 90 as a temperature control section for controlling the temperature of the substrate W. Additionally, the two anode units 90 and 90 are configured to be able to move in directions (horizontal directions) in which the anode units 90 come close to and separate from each other using the drive unit 71 provided at the side plate portion 63, and the distance between each substrate W and the cathode unit 68 is controllable. Specifically, when films are formed on the substrates W, the two anode units 90 and 90 move in a direction in which the anode units 90 and 90 are adjacent to the cathode unit 68, are in contact with the substrate W, and move in directions in which the anodes approach the cathode unit 68, thereby adjusting the distance between the substrates W and the cathode unit 68 as desired. Thereafter, films are formed, and the anode units 90 and 90 move in directions in which the anode units separate from each other after the end of film forming. Since the drive unit 71 is provided in this way, the substrates W can be easily taken out of the electrode unit 31. Moreover, each anode unit 90 is attached to the drive unit 71 via a hinge, and can be turned (opened) until the surface 67A of the anode unit 90 (anode 67) which faces the cathode unit 68 becomes substantially parallel to one surface 65 of the side plate portion 63, in a state in which the electrode unit 31 is pulled out of the film forming chamber 11.

That is, the anode unit 90 is configured so as to be able to turn by approximately 90° from the vertical direction of the bottom plate portion 62 (refer to FIG. 4A).

The cathode unit 68 has a shower plate 75 (=cathode), a cathode intermediate member 76, a discharge duct 79, a floating capacitance member 82, and a power feeding point 88. The shower plates 75 are arranged on both sides of the cathode unit 68 on the surface of the cathode unit 68 which faces the anode unit 90 (anode 67). The shower plate 75 is formed with a plurality of small holes (not shown), and jets the film forming gas toward the substrate W. Moreover, the shower plates 75 and 75 are cathodes (high-frequency electrodes) connected to the matching box 72. The cathode intermediate member 76 connected to the matching box 72 is provided between the two shower plates 75 and 75. That is, the shower plates 75 are arranged on both sides of the cathode intermediate member 76 in a state where the shower plates are electrically connected to the cathode intermediate member 76. The cathode intermediate member 76 and the shower plates (cathodes) 75 are formed from electrical conductors, and high frequency is applied to the shower plates (cathodes) 75 via the cathode intermediate member 76. For this reason, voltages of the same electrical potential and phase for generating plasma are applied to the two shower plates 75 and 75.

The cathode intermediate member 76 is connected to the matching box 72 via a wire that is not shown.

Space portions 77 are formed between the cathode intermediate member 76 and the shower plates 75. The space portions 77 are separated from each other by the cathode intermediate member 76, and are individually formed so as to correspond to the shower plates 75 and 75, respectively. That is, the cathode unit 68 is formed with a pair of space portions 77.

When the film forming gas is supplied to each of the space portions 77 from a gas supply device (not shown), the gas is released from the shower plates 75 and 75, respectively. That is, the space portion 77 has a role as a gas supply passage.

In the embodiment, the respective space portions 77 are separately formed so as to correspond to the shower plates 75 and 75, respectively. Thus, the cathode unit 68 has two-system gas supply passages. Therefore, the kind of gas, the flow rate of gas, the mixing ratio of gas, and the like are independently controlled for every system.

Moreover, a hollow discharge duct 79 is provided at a peripheral edge portion of the cathode unit 68 over its whole periphery.

The discharge duct 79 is formed with a vacuuming port 80 for sucking and removing (evacuating) the film forming gas or reactive by-products (powder) of a film formation space 81.

Specifically, the vacuuming port 80 is formed so as to communicate with the film formation space 81 formed between the substrate W and the shower plate 75 when a film is formed.

A plurality of vacuuming ports 80 is formed along the peripheral edge portion of the cathode unit 68, and is configured so that the film forming gas or reactive by-products (powder) can be sucked and removed substantially equally over its whole periphery.

Additionally, the surface of the discharge duct 79 which faces the inside of the film forming chamber 11 at the lower portion of the cathode unit 68 is formed with an opening (not shown). The film forming gas removed through the vacuuming ports 80 can be discharged into the film forming chamber 11 via this opening.

The gas discharged into the film forming chamber 11 is evacuated to the outside through the vacuuming pipe 29 provided at the lateral lower portion 28 of the film forming chamber 11.

Additionally, the floating capacitance member 82 which has a dielectric body and/or a laminated space is provided between the discharge duct 79 and the cathode intermediate member 76. The discharge duct 79 is connected to the ground potential. The discharge duct 79 also functions as a shield frame for preventing abnormal electrical discharge from the cathode 75 and the cathode intermediate member 76.

Moreover, masks 78 are provided at the peripheral edge portion of the cathode unit 68 so as to cover the part from the peripheral portion of the discharge duct 79 to the peripheral portion of the shower plate 75.

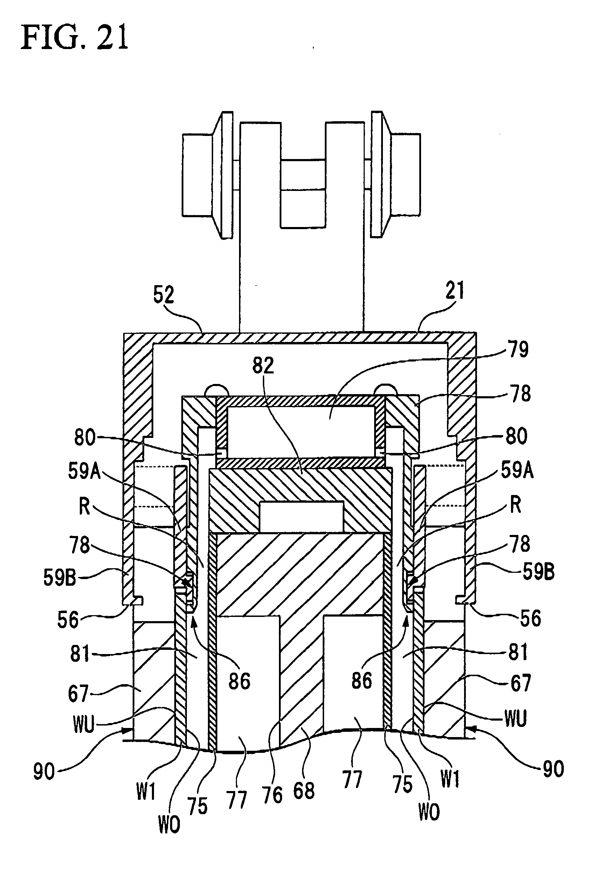

Each mask 78 covers a holding piece 59A (refer to FIGS. 9 and 21) of a holding portion 59 (which will be described later) provided at the carrier 22, and forms a gas flow passage R for guiding the film forming gas or particles of the film formation space 81 to the discharge duct 79, integrally with the holding piece 59A when a film is formed.

That is, the gas flow passage R is formed between the carrier 21 (holding piece 59A), and the shower plate 75 or the discharge duct 79.

Since the electrode unit 31 is configured in this way, in one electrode unit 31, two gaps are formed between the anode units 90 and the cathode unit 68 into which substrates W are inserted. Accordingly, films can be simultaneously formed on two substrates W by one electrode unit 31.

Additionally, the substrate W is disposed between each anode unit 90 and the cathode unit 68, and the anode unit 90 (anode 67) is in contact with the substrate W, and is movable in order to adjust the distance from the substrate W and the cathode unit 68. For this reason, when a thin-film Si-layer is formed on the substrate W by the plasma CVD method, it is necessary to set the gap between the substrate W and the cathode unit 68 to be approximately 5 to 15 mm. However, since the anode 67 is movable, the distance between the anode 67 and the cathode unit 68 can be adjusted before and after film forming. Accordingly, entrance or exit of the substrate W can be made easier. Additionally, when the substrate W enters and exits the film forming chamber, it is possible to prevent the substrate W from being in contact with and being damaged by the anode 67 or the cathode unit 68. Moreover, during film forming, a film is formed while the substrate W is heated by the heater H. According to the above-described configuration, since the anode 67 and the substrate W can be in contact with each other, the heat of the heater H can be effectively transferred to the substrate W. Accordingly, high-quality film forming can be performed.

Moreover, in the cathode unit 68 and anode units 90 of the electrode unit 31, it is necessary to perform maintenance periodically for the removal of films deposited on these units. As described above, since the electrode unit 31 is configured so as to be attachable to and detachable from the film forming chambers 11, maintenance can be easily performed. Additionally, if a spare electrode unit 31 is prepared, the spare electrode unit 31 can be attached to the film forming chamber 11 instead of an electrode unit 31 for which the maintenance is necessary even if the electrode unit 31 is removed from the film forming chamber 11 for maintenance. In this case, maintenance can be performed without stopping the manufacturing line. Accordingly, production efficiency can be improved. As a result, a high throughput can be realized even when a low-rate semiconductor layer is formed on the substrate W.

Returning to FIG. 2, transfer rails 37 are laid between the film forming chamber 11 and the substrate-replacement chamber 15 so that the carrier 21 can be transferred between the film forming chamber 11 and the loading-ejecting chamber 13 and between the loading-ejecting chamber 13 and the substrate-replacement chamber 15.

In addition, the transfer rails 37 are separated between the film forming chamber 11 and the loading-ejecting chamber 13, and the carrier transfer inlet ports 24 can be sealed by closing the shutters 25.

FIGS. 5A and 5B are schematic configuration views of the loading-ejecting chamber 13, and FIG. 5A is a perspective view, and FIG. 5B is a perspective view as seen from an angle different from the angle of FIG. 5A.

As shown in FIGS. 5A and 5B, the loading-ejecting chamber 13 is formed in the shape of a box.

A lateral surface 33 is connected to the lateral surface 23 of the film forming chamber 11 securing airtightness.

The lateral surface 33 is formed with an opening 32 through which three carriers 21 can be inserted.

A lateral surface 34 which is opposite to the lateral surface 33 is connected to the substrate-replacement chamber 15.

The lateral surface 34 is formed with three carrier transfer inlet ports 35 which allow the carrier 21 on which the substrates W are mounted to pass therethrough.

Each carrier transfer inlet port 35 is provided with a shutter 36 (second opening-closing section) which can secure airtightness. In addition, the transfer rails 37 are separated between the loading-ejecting chamber 13 and the substrate-replacement chamber 15, and the carrier transfer inlet ports 35 can be sealed by closing the shutters 36.

Additionally, the loading-ejecting chamber 13 is provided with a push-pull mechanism 38 for transferring the carrier 21 between the film forming chamber 11 and the loading-ejecting chamber 13 along the transfer rails 37.

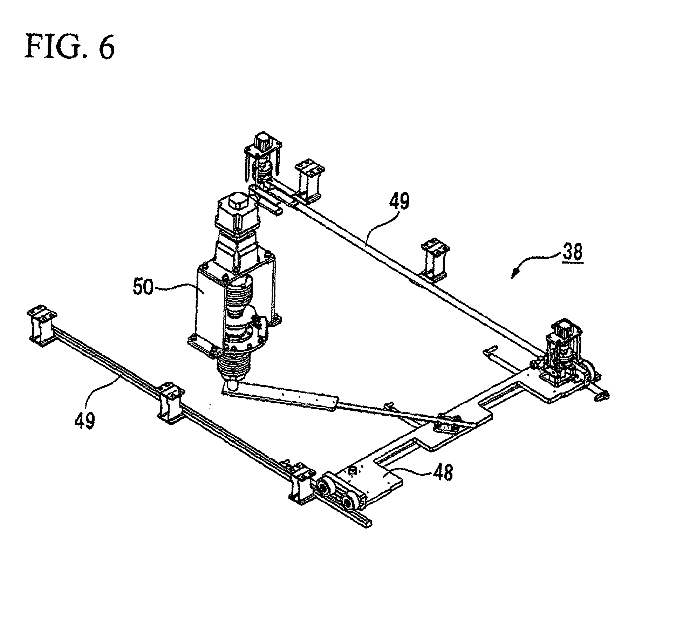

As shown in FIG. 6, the push-pull mechanism 38 includes a locking portion 48 for locking the carrier 21; a pair of guide members 49 provided at both ends of the locking portion 48 and disposed substantially parallel to the transfer rails 37; and a transfer device 50 for moving the locking portion 48 along both of the guide members 49.

Moreover, a transfer mechanism (not shown) for transferring the carrier 21 by a predetermined distance in a direction substantially orthogonal to the direction in which the transfer rails 37 are laid in plan view (when the surface on which the loading-ejecting chamber 13 is installed is seen from the vertical direction), is provided within the loading-ejecting chamber 13 in order to simultaneously store the pre-processed substrate W1 and the post-processed substrate W2.

A vacuuming pipe 42 for reducing the pressure inside of the loading-ejecting chamber 13 is connected to a lateral lower portion 41 of the loading-ejecting chamber 13 so that the chamber has a vacuum atmosphere, and a vacuum pump 43 is connected to the vacuuming pipe 42.

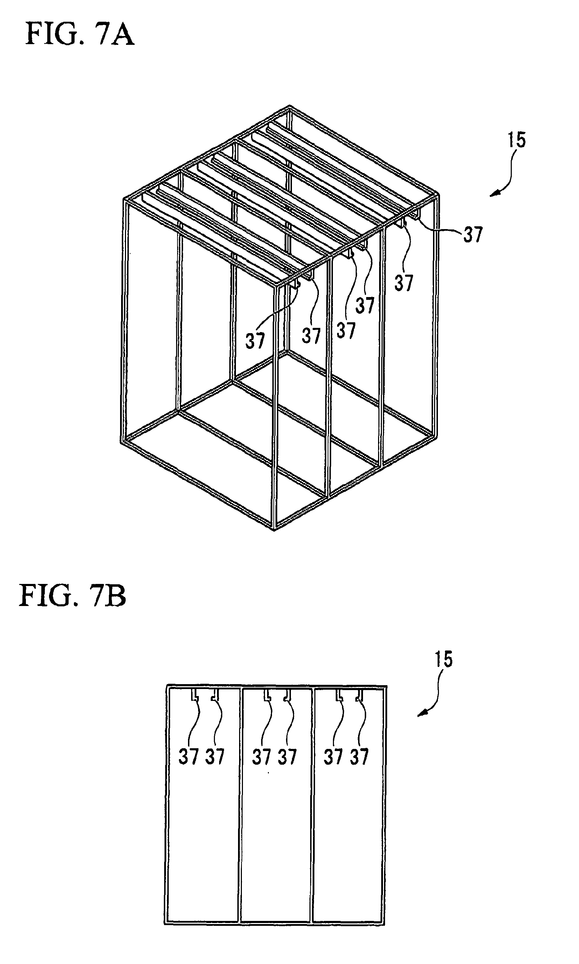

FIGS. 7A and 7B are schematic configuration views of the substrate-replacement chamber, FIG. 7A is a perspective view, and FIG. 7B is a front view.

As shown in FIGS. 7A and 7B, the substrate-replacement chamber 15 is formed in the shape of a frame, and is connected to the lateral surface 34 of the loading-ejecting chamber 13.

In the substrate-replacement chamber 15, the pre-processed substrates W1 can be attached to the carrier 21 disposed at the transfer rails 37, and the post-processed substrate W2 can be removed from the carrier 2.

Three carriers 21 are configured to be able to be arranged in parallel at the substrate-replacement chamber 15.

The substrate replacement robot 17 has a drive arm 45, and has a suction portion which sucks the substrate W on the tip of the drive arm 45 (refer to FIG. 2).

Additionally, the drive arm 45 is driven between the carrier 21 and the substrate storage holder 19 which are disposed at the substrate-replacement chamber 15. Specifically, the drive arm 45 can take out the pre-processed substrate W1 from the substrate storage holder 19, and attach the pre-processed substrate W1 to the carrier 21 (first carrier) disposed at the substrate-replacement chamber 15, and can remove the post-processed substrate W2 from the carrier 21 (second carrier) which has returned to the substrate-replacement chamber 15, and convey the substrate to the substrate storage holder 19.

FIG. 8 is a perspective view of the substrate storage holder 19.

As shown in FIG. 8, the substrate storage holder 19 is formed in the shape of a box, and has a size such that the holder can store a plurality of substrates W.

A plurality of substrates W can be stored in a stacked manner in the up-and-down direction within the substrate storage holder 19 in a state where the surfaces to be film-formed of the substrates W are made horizontal.

Additionally, casters 47 are provided at a lower portion of the substrate storage holder 19 so as to allow for movement to separate processing apparatuses (exterior of the thin-film solar cell manufacturing apparatus 10) different from the thin-film solar cell manufacturing apparatus 10.

FIG. 9 is a perspective view of the carrier 21. As shown in FIG. 9, the carrier 21 is used to convey the substrates W, and includes two frame-like frames 51 to which the substrates W can be attached. That is, two substrates W can be attached in one carrier 21. Two frames 51 and 51 are integrated together by a connection member 52 at the upper portions thereof.

Additionally, wheels 53 to be placed on the transfer rails 37 are provided above the connection member 52. When the wheels 53 roll on the transfer rails 37, the carrier 21 is movable along the transfer rails 37.

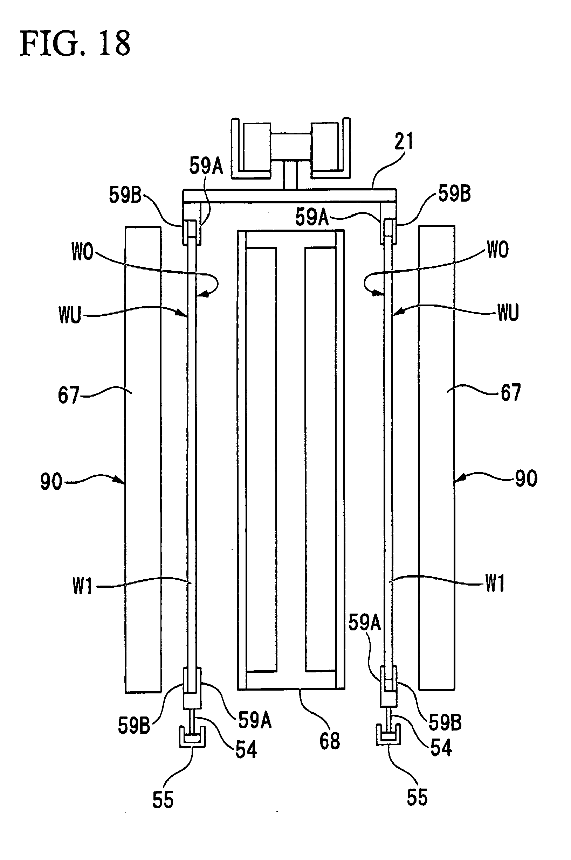

Additionally, a lower portion of each frame 51 is provided with a frame holder 54 for suppressing the shaking of the substrate W when the carrier 21 is transferred. The tip of the frame holder 54 is fitted into a rail member 55 (refer to FIG. 18) formed in a recessed shape in a cross-section, the rail member 55 being provided on the bottom surface of each chamber. In addition, the rail members 55 are disposed in a direction along the transfer rails 37 in plan view (when the surface on which the rail members 55 are installed is seen from the vertical direction).

Additionally, the carrier 21 can be more stable if the frame holder 54 is constituted of a plurality of rollers.

Each frame 51 has an opening 56, a peripheral edge portion 57 and a holding portion 59. When the substrate W is mounted to the frame 51, the surface to be film-formed of the substrate W is exposed at the opening 56. Additionally, both surfaces of the substrate W are held by the peripheral edge portion 57 of the opening 56 and the holding portion 59, and the substrate W is fixed to the frame 51. A biasing force caused by a spring or the like acts on the holding portion 59 which holds the substrate W.

Additionally, the holding portion 59 has holding pieces 59A and 59B which is to contact the front surface WO (surface to be film-formed) and rear surface WU (back surface) of the substrate W (refer to FIG. 21). The distance between the holding pieces 59A and 59B is variable via the spring or the like, that is, the holding piece 59A is configured to be movable along the directions in which the holding piece comes close to and separates from the holding piece 59B according to the movement of the anode unit 90 (anode 67) (the details of which will be described later).

Here, one carrier 21 is attached on one transfer rail 37. That is, one carrier 21 which can hold a pair of substrates (two substrates in total) is attached onto one transfer rail 37. That is, in one film forming chamber 11, three carriers 21 are attached, that is, three pairs of substrates (six substrates in total) are held.

In the thin-film solar cell manufacturing apparatus 10 of the embodiment, four substrate film formation lines 16 each constituted of the above-described film forming chamber 11, a loading-ejecting chamber 13, and a substrate-replacement chamber 15 are arranged (refer to FIG. 2), and three carriers 21 are stored in one film forming chamber (refer to FIGS. 3A and 3B). Therefore, films can be substantially simultaneously formed on twenty four substrates W.

### (Method for Manufacturing Thin-film Solar Cell)

Next, a method for forming a film on a substrate W will be described using the thin-film solar cell manufacturing apparatus 10 of the embodiment. In addition, although this description is made using drawings of one substrate film formation line 16, films are formed on substrates by substantially the same method as the method described below in the other three substrate film formation lines 16.

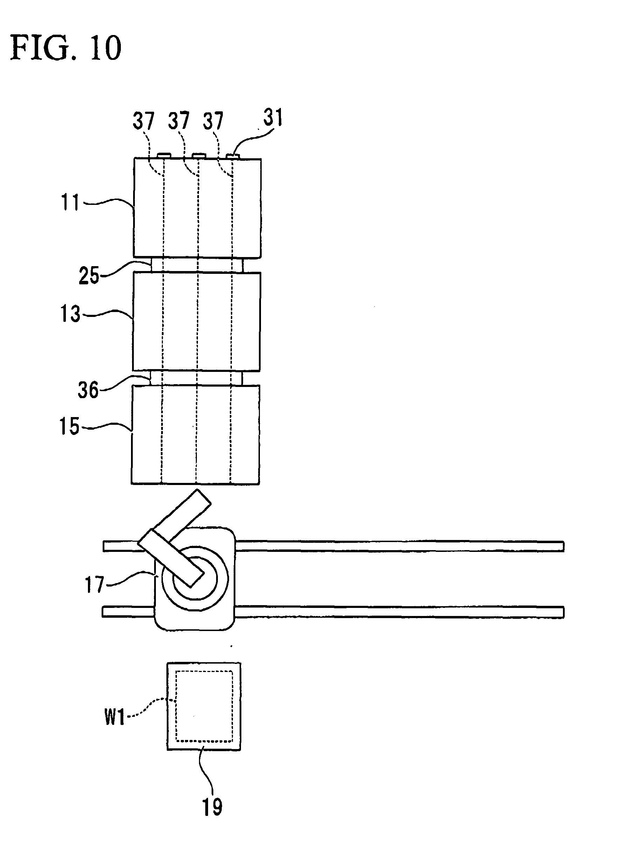

First, as shown in FIG. 10, the substrate storage holder 19 which stores a plurality of pre-processed substrates W1 is arranged at a predetermined position.

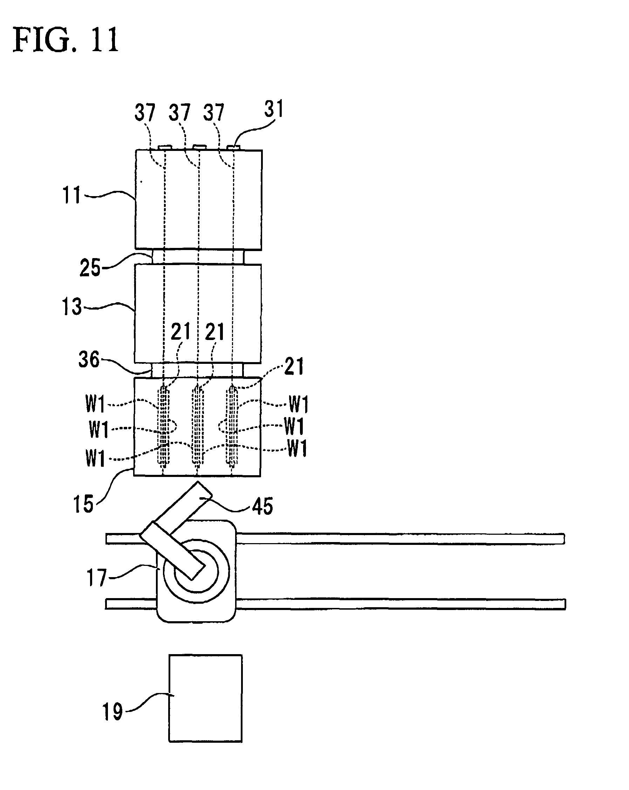

Next, as shown in FIG. 11, the drive arm 45 of the substrate replacement robot 17 is operated to take one pre-processed substrate W1 out of the substrate storage holder 19, and attaches the pre-processed substrate W1 to a carrier 21 installed within the substrate-replacement chamber 15. At this time, the arrangement direction of the pre-processed substrate W1 which has been arranged in the horizontal direction in the substrate storage holder 19 varies in the vertical direction, and the pre-processed substrate W1 is attached to the carrier 21. This operation is repeated once again to attach two pre-processed substrates W1 to one carrier 21.

Moreover, this operation is repeated to attach the pre-processed substrates W1 with each of the remaining two carriers 21 installed within the substrate-replacement chamber 15. That is, six pre-processed substrates W1 are attached in this step.

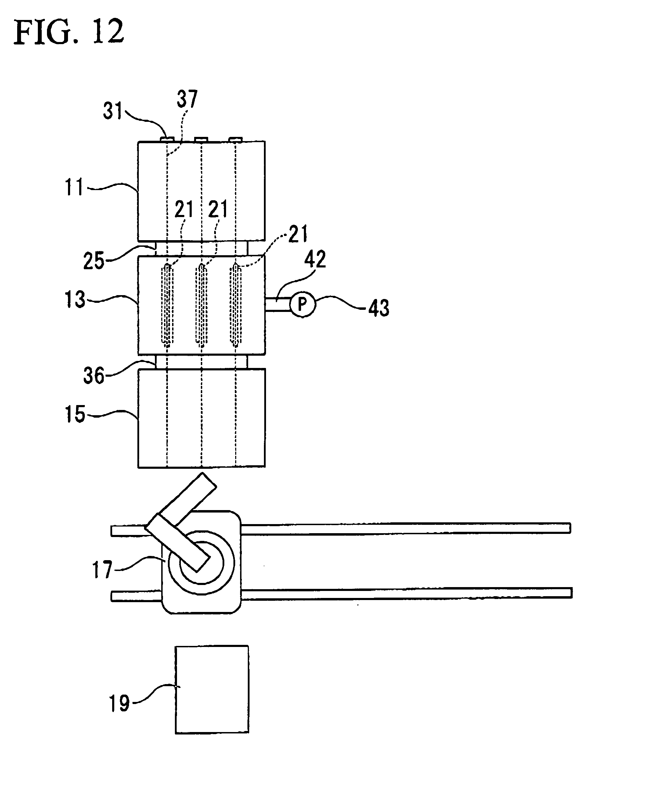

Subsequently, as shown in FIG. 12, the three carriers 21 to which the pre-processed substrates W1 are attached are substantially simultaneously transferred along the transfer rails 37, and are stored within the loading-ejecting chamber 13. After the carriers 21 are stored within the loading-ejecting chamber 13, the shutters 36 of the carrier transfer inlet ports 35 of the loading-ejecting chamber 13 are closed.

Thereafter, the inside of the loading-ejecting chamber 13 is held in a vacuum state using the vacuum pump 43.

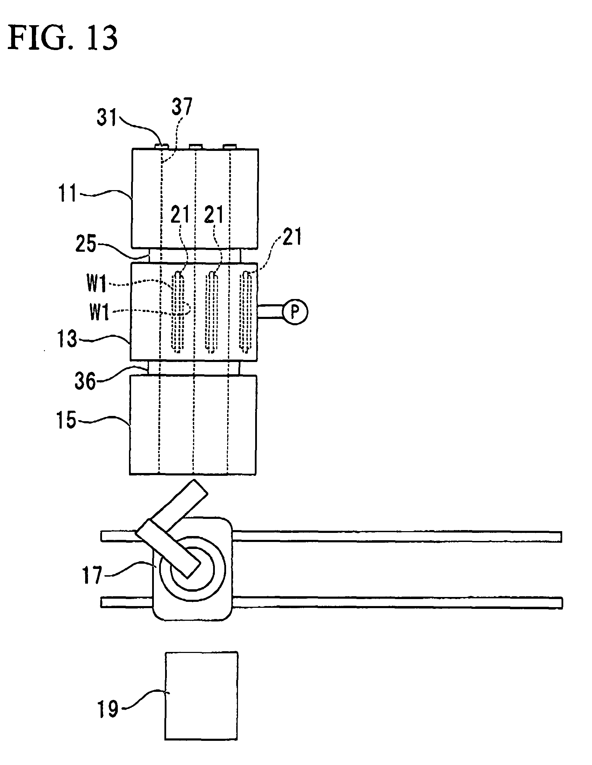

Thereafter, as shown in FIG. 13, the three carriers 21 are transferred using the transfer mechanism by a predetermined distance (half pitch), respectively, in a direction orthogonal to a direction in which the transfer rails 37 are laid in plan view (when the surface on which the loading-ejecting chamber 13 is installed is seen from the vertical direction).

In addition, the predetermined distance is a distance between which one carrier 21 moves on adjacent transfer rails 37.

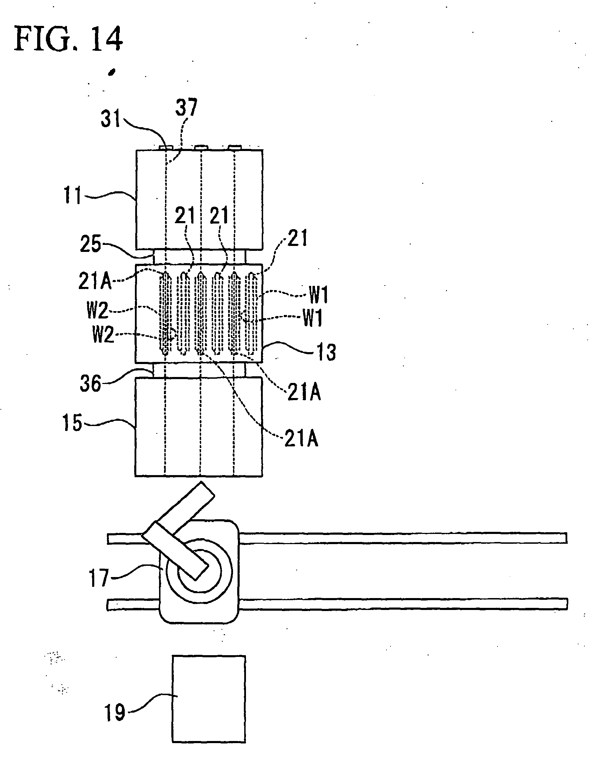

Next, as shown in FIG. 14, the shutters 25 of the film forming chamber 11 are opened, and the carriers 21 A to which the post-processed substrates W2 that has been film-forming processed in the film forming chamber 11 are attached are transferred into the loading-ejecting chamber 13, using the push-pull mechanism 38.

At this time, in plan view, the carrier 21 to which the pre-processed substrates W1 are attached, and the carrier 21 A to which the post-processed substrate W2 are attached are arranged in parallel.

By holding this state for a predetermined time, the heat which is accumulated in the post-processed substrates W2 is transferred to the pre-processed substrates W1.

That is, the substrates W1 before film forming are heated.

Here, the operation of the push-pull mechanism 38 will be described. In addition, the operation when the carriers 21A located within the film forming chamber 11 are transferred into the loading-ejecting chamber 13 will be described here.

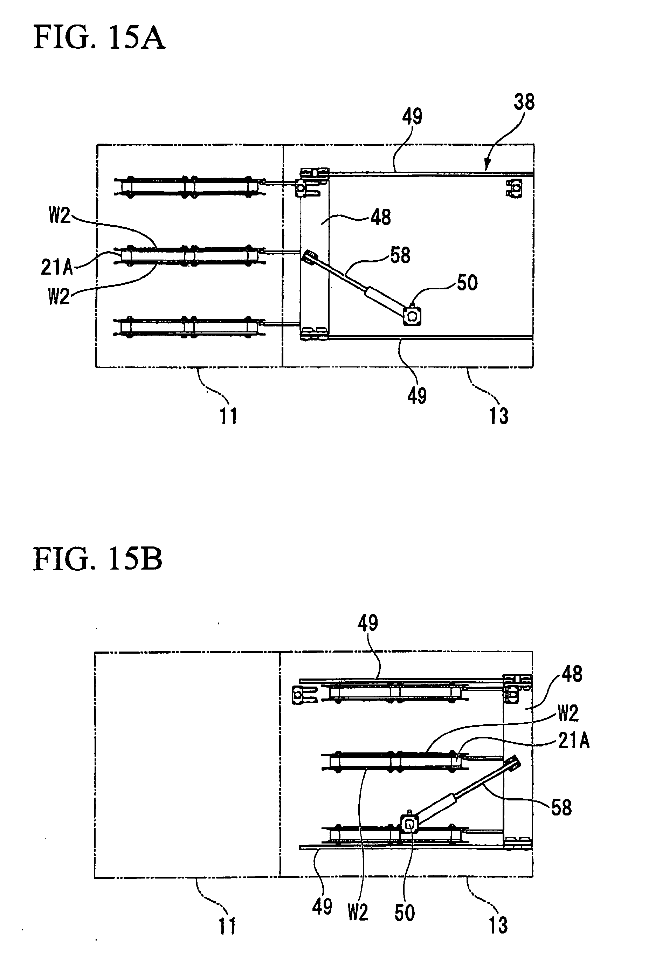

As shown in FIG. 15A, the carriers 21A to which the post-processed substrates W2 are attached are locked to the locking portion 48 of the push-pull mechanism 38. Then, the transfer arm 58 of the transfer device 50 attached to the locking portion 48 is swung. At this time, the length of the transfer arm 58 is variable. Then, the locking portion 48 to which the carriers 21 A have been locked moves while being guided by the guide members 49, and as shown in FIG. 15B, moves into the loading-ejecting chamber 13. That is, the carriers 21A are transferred to the loading-ejecting chamber 13 from the film forming chamber 11.

According to such a configuration, it becomes unnecessary to provide a drive source (drive mechanism) for driving the carriers 21A within the film forming chamber 11.

In addition, in contrast to the operation of transferring the carrier as described above, by transferring the carrier by the push-pull mechanism 38 due to a reverse operation, it is possible to move the carrier from the loading-ejecting chamber 13 to the film forming chamber 11.

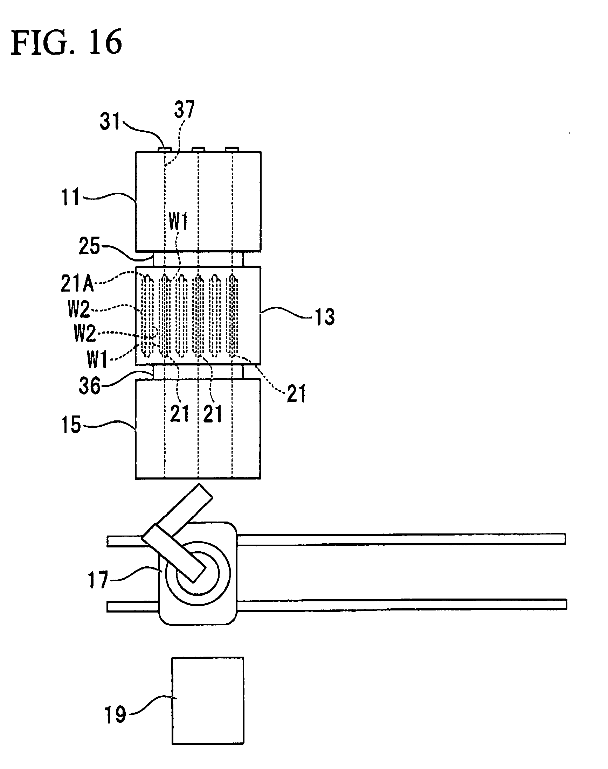

Next, as shown in FIG. 16, the carriers 21 and the carriers 21A are transferred in a direction orthogonal to the transfer rails 37 by the transfer mechanism, and the respective carriers 21 holding the pre-processed substrates W1 are transferred to the positions of the respective transfer rails 37.

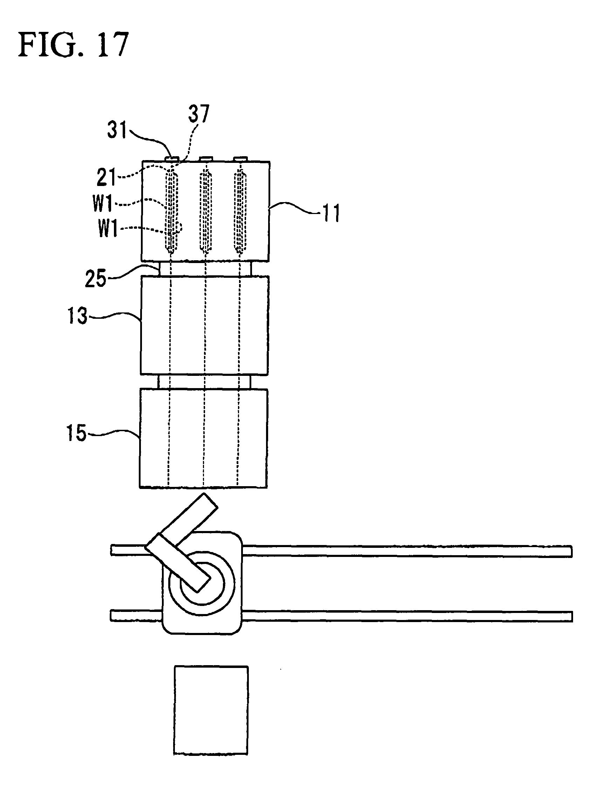

Subsequently, as shown in FIG. 17, the carriers 21 holding the pre-processed substrates W1 are transferred to the film forming chamber 11, using the push-pull mechanism 38, and the shutters 25 are closed after the completion of transfer. In addition, the film forming chamber 11 is held in a vacuum state.

At this time, the pre-processed substrates W1 attached to the carrier 21 move along a direction parallel to the surfaces thereof, and are inserted between the anode units 90 and the cathode unit 68 within the film forming chamber 11 in a state along the vertical direction so that the front surfaces WO become substantially parallel to the direction of gravitational force (refer to FIG. 18).

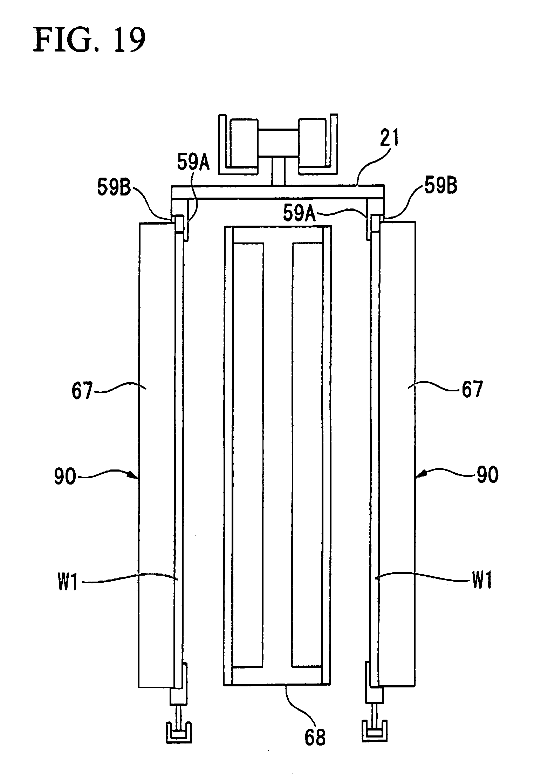

Next, as shown in FIGS. 18 and 19, the two anode units 90 and the rear surfaces WU of the pre-processed substrates W1 are in contact with each other by moving the anode units 90 of the electrode unit 31 in directions in which the anodes approach each other using the drive unit 71.

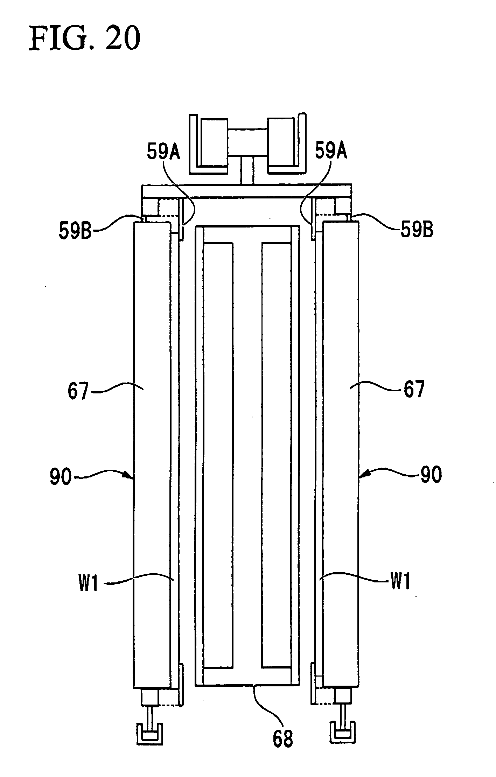

As shown in FIG. 20, when the drive unit 71 is further driven, the pre-processed substrates W1 move toward the cathode unit 68 so as to be pushed by the anodes 67.

Moreover, the pre-processed substrates W1 are moved until the gap between the pre-processed substrate W1 and the shower plate 75 of the cathode unit 68 reaches a predetermined distance (film forming distance).

In addition, the gap (film forming distance) between the pre-processed substrate W1 and the shower plate 75 of the cathode unit 68 is 5 to 15 mm, and is, for example, approximately 5 mm.

At this time, the holding piece 59A of the holding portion 59 of the carrier 21 which is in contact with the front surface WO of the pre-processed substrate W1 is displaced in a direction away from the holding piece 59B along with the movement (movement of the anode unit 90) of the pre-processed substrate W1. The substrate W1 before film forming at this time is held by the anode 67 and the holding piece 59A. In addition, when the anode unit 90 has moved in the direction away from the cathode unit 68, since the restoring force of a spring or the like acts on the holding piece 59A, the holding piece 59A moves toward the holding piece 59B.

When the pre-processed substrate W1 moves toward the cathode unit 68, the holding piece 59A is in contact with the mask 78, and the movement of the anode unit 90 stops at this time (refer to FIG. 21).

As shown in FIG. 21, the mask 78 is formed so as to cover the surface of the holding piece 59A and the outer-edge portion of the glass substrate W and come into close contact with the holding piece 59A or the outer-edge portion of the substrate W. The film formation space 81 is formed by the mask 78, the shower plate 75 of the cathode unit 68, and the pre-processed substrate W1 (substrate W).

That is, a mating surface (contacting surface) between the mask 78 and the holding piece 59A or the outer-edge portion of the substrate W functions as a seal portion 86. With this configuration, the film forming gas is prevented from leaking out from between the mask 78 and the holding piece 59A or from between the mask 78 and the outer-edge portion of the substrate W toward the anode 67. Therefore, the scope in which the film forming gas spreads is limited, and it is possible to suppress a film formation on an unnecessary scope. For this reason, it is possible to narrow down a scope to be cleaned, and to reduce a frequency for cleaning, and the operating rate of the apparatus improves.

Additionally, since the movement of the pre-processed substrate W1 stops when the holding piece 59A or the outer-edge portion of the substrate W is in contact with the mask 78, the gap between the mask 78 and the shower plate 75 and the gap between the mask 78 and the discharge duct 79, that is, the flow passage height of the gas flow passage R in its thickness direction (direction vertical to the plane of the shower plate 75) is set so that the gap between the pre-processed substrate W1 and the cathode unit 68 becomes a predetermined distance.

Additionally, as a modified example of the embodiment, a structure can be adopted in which the distance between the substrate and the shower plate 75 (=cathode) can also be optionally changed due to the stroke of the drive unit 71 by attaching the mask to the discharge duct 79 via an elastic body.

In the above embodiment, a case where the mask 78 and the substrate W are in contact with each other has been described. However, the mask 78 and the substrate W may be arranged so as to leave a very small gap which limits the passage of the film forming gas.

In a state where the substrate W is arranged as described above, the film forming gas is jetted from the shower plate 75 of the cathode unit 68, and a voltage is applied to the shower plate (=cathode) 75 of the cathode unit 68 by starting the matching box; therefore, a plasma is generated in the film formation space 81, and a film is formed on the front surface WO of the pre-processed substrate W1.

At this time, the pre-processed substrate W1 is heated to a desired temperature by the heater H built in the anode 67.

Here, the anode unit 90 stops heating when the pre-processed substrate W1 reaches a desired temperature.

Plasma is generated within the film formation space 81 by applying a voltage to the cathode unit 68. Even if the heating of the anode unit 90 is stopped, there is a possibility that the temperature of the pre-processed substrate W1 may rise higher than a desired temperature due to the heat input from the plasma with the passage of time. In this case, the anode unit 90 can also be made to function as a radiator plate for cooling the pre-processed substrate W1 of which the temperature has risen excessively. Accordingly, the temperature of the pre-processed substrate W1 is maintained at a desired temperature irrespective of the passage of the film formation processing time.

In addition, a plurality of layers can be film-formed on the substrate W through one film formation processing process by switching a film forming gas material to be supplied from the shower plate 75 at each predetermined time.

Additionally, during film forming and after film forming, the gas or particles within the film formation space 81 is sucked and removed (evacuated) through the vacuuming ports 80 formed in the peripheral edge portion of the cathode unit 68. Specifically, the gas or reactive by-products within the film formation space 81 is evacuated to the discharge duct 79 of the peripheral edge portion of the cathode unit 68 via the gas flow passage R and the vacuuming ports 80. Thereafter, the gas or reactive by-products (powder) pass through an opening formed in the surface of the discharge duct 79 which faces the inside of the film forming chamber 11 at the lower portion of the cathode unit 68. The gas or reactive by-products are evacuated to the outside of the film forming chamber 11 through the vacuuming pipe 29 provided at the lateral lower portion 28 of the film forming chamber 11.

In addition, the reactive by-products generated when a film is formed can be collected and disposed of when the reactive by-products are made to adhere to and be deposited on the inner wall surface of the discharge duct 79.

Since the same processing as the above-described processing is executed in all the electrode units 31 in the film forming chamber 11, films can be simultaneously formed on all six substrates.

When the film formation is ended, the two anode units 90 are moved in directions in which the anode units 90 are separated from each other using the drive unit 71, and the post-processed substrates W2 and the frames 51 (holding pieces 59A) are returned to their original positions (refer to FIGS. 19 and 21). Moreover, by moving the anode units 90 in directions in which the anode units 90 are separated from each other, the post-processed substrates W2 are separated from the anode units 90 (refer to FIG. 18).

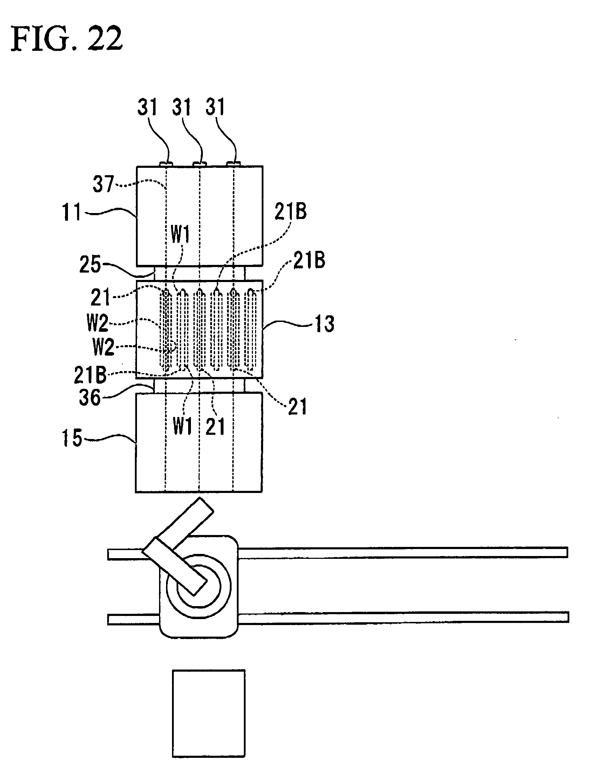

Next, as shown in FIG. 22, the shutters 25 of the film forming chamber 11 are opened, and the carrier 21 is transferred to the loading-ejecting chamber 13, using the push-pull mechanism 38.

At this time, the inside of the loading-ejecting chamber 13 is maintained in a vacuum state, and the carriers 21B to which the pre-processed substrates W1 to be film-formed next are already arranged.

Then, the heat accumulated in the post-processed substrates W2 is transferred to the pre-processed substrates W1 within the loading-ejecting chamber 13, and the temperature of the post-processed substrates W2 is lowered.

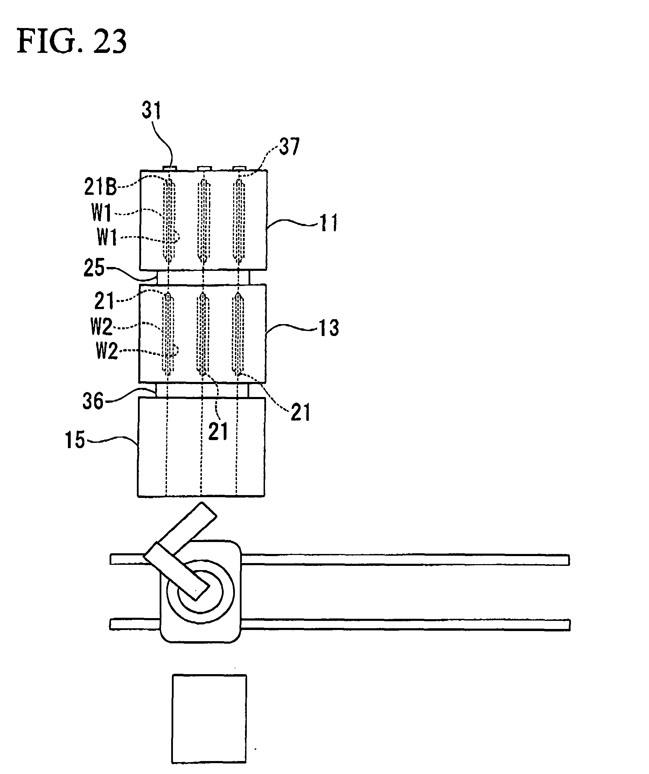

Subsequently, as shown in FIG. 23, after each carrier 21B is transferred into the film forming chamber 11, each carrier 21 is returned to the position of the transfer rails 37 by the transfer mechanism.

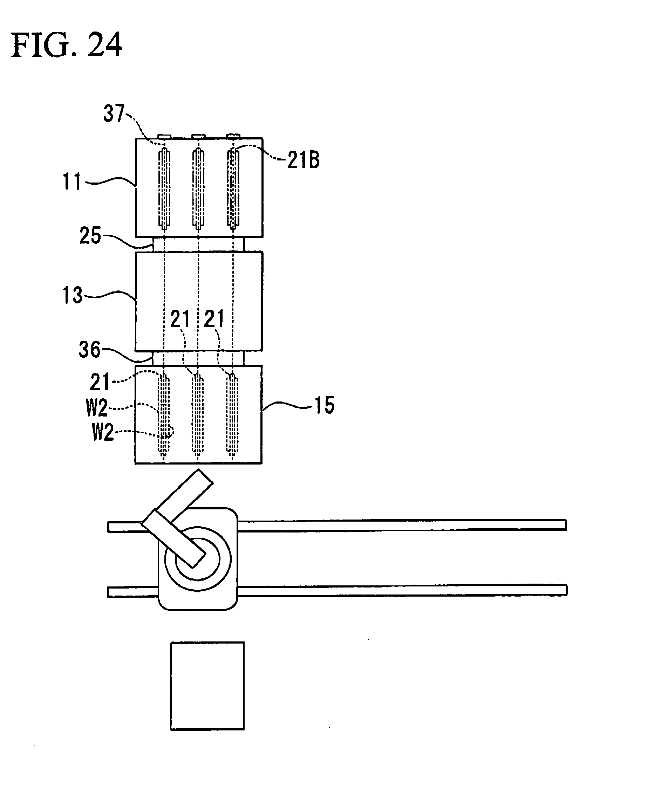

Next, as shown in FIG. 24, after the shutters 25 are closed, and after a temperature of post-processed substrates W2 decreases to a predetermined temperature, the shutters 36 are opened, and the carriers 21 are transferred to the substrate-replacement chamber 15.

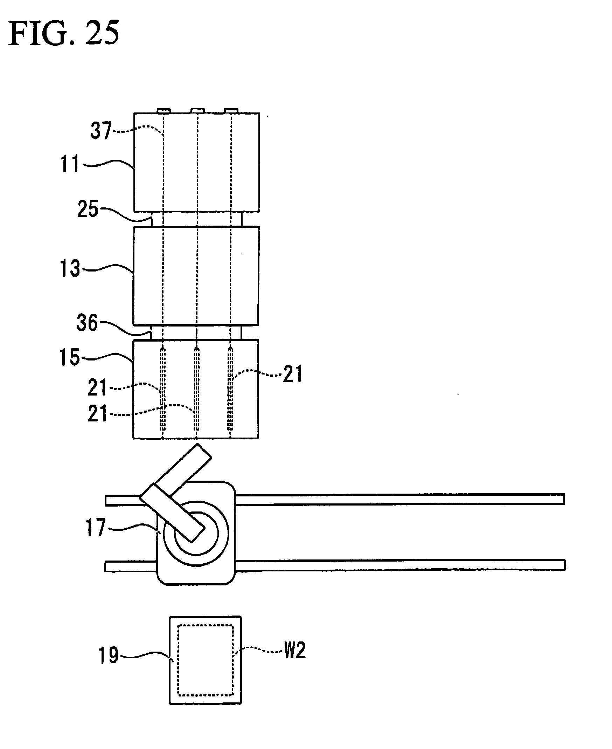

Next, as shown in FIG. 25, each post-processed substrate W2 is removed from the carrier 21 by the substrate replacement robot 17 in the substrate-replacement chamber 15, and is conveyed to the substrate storage holder 19.

When removal of all the post-processed substrates W2 is completed, the film formation processing is ended by moving the substrate storage holder 19 to a place (apparatus) where the following process is performed.

According to the thin-film solar cell manufacturing apparatus 10 of the present embodiment, the carrier 21 in which the pre-film-formation-processed substrate W1 which is to be transported to the film forming chamber 11 is held, and the carrier 21 (21 A) in which the post-film-formation-processed substrate W2 which has been transported from the film forming chamber 11 is held can be simultaneously stored in the loading-ejecting chamber 13. For this reason, the number of processes switching the atmosphere within the loading-ejecting chamber to a vacuum atmosphere or air atmosphere can be reduced. Accordingly, the productivity can be improved. Moreover, when the pre-film-formation-processed substrate W1 and the post-film-formation-processed substrate W2 are simultaneously stored in the loading-ejecting chamber 13, the heat accumulated in the post-film-formation-processed substrate W2 is transferred to the pre-film-formation-processed substrate W1, whereby heat exchange is performed. That is, a heating process which is usually performed after the pre-film-formation-processed substrate W1 is stored in the film forming chamber 11, and a cooling process which is usually performed before the post-film-formation-processed substrate W2 is transported from the loading-ejecting chamber 13 can be omitted. As a result, the productivity can be improved, and manufacturing costs can be reduced because facilities used for conventional heating and cooling processes can be omitted.

Additionally, since a plurality of carriers 21 holding the pre-film-formation-processed substrates W1 and a plurality of carriers 21 (21A) holding the post-film-formation-processed substrates W2 can be simultaneously stored in the loading-ejecting chamber 13, respectively, films can be simultaneously formed on a plurality of substrates W, and productivity can be improved. Additionally, since a plurality of carriers 21 which is to be transported to the film forming chamber 11 and a plurality of carriers 21 (21A) which has been transported from the film forming chamber 11 can be simultaneously stored in the loading-ejecting chamber 13, the number of processes switching the atmosphere within the loading-ejecting chamber to a vacuum atmosphere or air atmosphere can be further reduced, and productivity can be further improved.

Additionally, a substrate W can be moved and be subjected to film formation within the thin-film solar cell manufacturing apparatus 10, in a state where the substrate W is erected in the vertical direction so that the film formation face of the substrate W and the direction of gravitational force become substantially parallel to each other. Therefore, the area required for the substrate W to move within the thin-film solar cell manufacturing apparatus 10 can be reduced. Accordingly, the apparatus can be miniaturized, and a larger number of apparatuses can be arranged in the same installation area as a conventional technique. Accordingly, the number of substrates W on which films can be simultaneously formed can be increased, and productivity can be improved. Additionally, when a film is formed on a substrate W in a state where the substrate W is erected in the vertical direction, particles generated when a film is formed can be kept from being deposited on the film formation face of the substrate W. Accordingly, a high-quality semiconductor layer can be film-formed on the substrate W.

Additionally, since the carrier 21 can hold a plurality of (two) substrates W, films can be simultaneously formed on a plurality of substrates W in one carrier 21, and productivity can be further improved. Moreover, since a plurality of carriers 21 can be simultaneously conveyed to the film forming chamber 11, the processing speed can be further increased.

Additionally, as shown in FIG. 2, a plurality of (4 sets) process modules 14 in which one film forming chamber 11 is connected to one loading-ejecting chamber 13 is provided, and the process modules 14 are arranged in parallel. For this reason, the number of substrates W on which films can be simultaneously formed can be further increased. Accordingly, a high throughput can be realized even when a low-rate film is formed on the substrate W. Additionally, since the apparatus is integrated into the process module 14, the installation time (building time of a manufacturing line) of the apparatus when the manufacturing line is built in a factory or the like can be shortened. Moreover, when maintenance of the film forming chamber 11 is performed, it is possible to perform the maintenance on each process module 14 in turn, and it becomes unnecessary to stop the whole manufacturing line. Accordingly, a decrease in production efficiency during maintenance can be suppressed to a minimum.

Moreover, since the substrate replacement robot 17 performs the operation of attaching the pre-film-formation-processed substrate W1 to the carrier 21 and the operation of removing the post-film-formation-processed substrate W2 from the carrier 21 in the substrate-replacement chamber 15, the substrate W can be efficiently attached to and detached from the carrier 21, and this can contribute to improvements in productivity.

Since the substrate storage holder 19, which is configured so as to store the substrate W and be able to be conveyed toward separate processing apparatuses different from the thin-film solar cell manufacturing apparatus 10, is provided, the substrate W can be efficiently conveyed to separate processing processes. Therefore, this can contribute to improvement in productivity.

In addition, the technical scope of the present invention is not limited to the above-described embodiments, but that various modifications of the above-described embodiments may be made without departing from the scope of the invention. That is, the specific shapes and configurations as mentioned in the embodiments are merely examples, and can be appropriately changed.

Although the case where one loading-ejecting chamber was connected to one film forming chamber has been described in the present embodiment, for example, the configurations to be described in Modifications 1 to 3 may be adopted.

### (Modification 1)

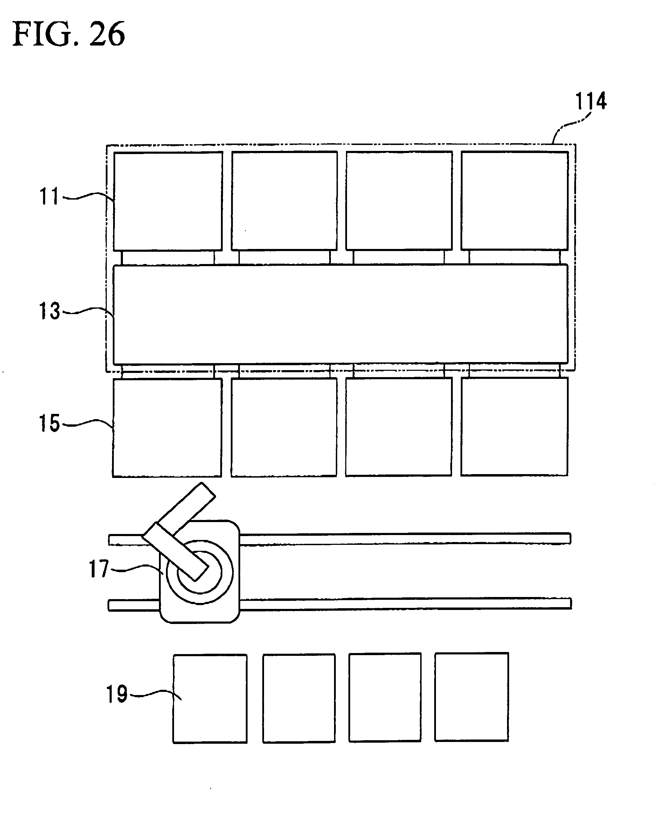

FIG. 26 is a schematic configuration view showing Modification 1 of the apparatus for manufacturing a thin-film solar cell.

As shown in FIG. 26, the apparatus for manufacturing a thin-film solar cell has a process module 114 configured so that a plurality of film forming chambers is connected to one large loading-ejecting chamber. Here, a plurality of film forming chambers is arranged in parallel. Additionally, the process module 114 may be configured so that a carrier can move into the loading-ejecting chamber. According to this configuration, a substrate attached to a carrier within the loading-ejecting chamber can be moved. For this reason, when different film forming materials are respectively supplied to a plurality of film forming chambers (when different films are formed in the film forming chambers, respectively), a substrate is conveyed through the loading-ejecting chamber between a plurality of film forming chambers, and different kinds of film forming materials are sequentially laminated on the substrate. Through this, a film can be efficiently formed on a substrate which has a multilayer structure.

### (Modification 2)

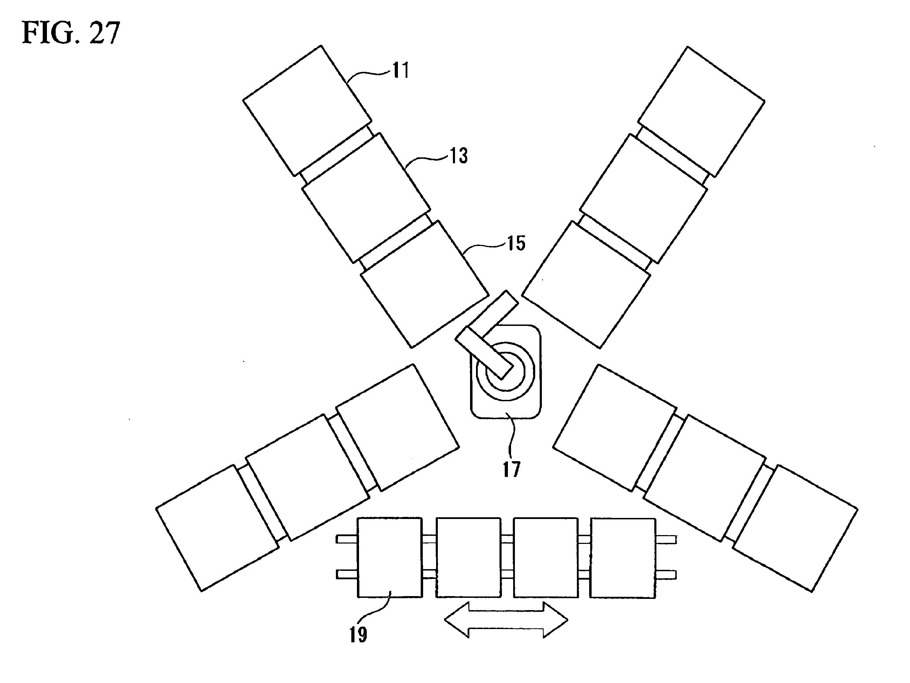

FIG. 27 is a schematic configuration view showing Modification 2 of the apparatus for manufacturing a thin-film solar cell.

As shown in FIG. 27, in the apparatus for manufacturing a thin-film solar cell, modules each including a film forming chamber 11, a loading-ejecting chamber 13, and a substrate-replacement chamber 15 are installed so as to extend radially from the substrate replacement robot 17. In such a configuration, the time for which the substrate replacement robot moves on the rails can be eliminated. That is, the operating time of the substrate replacement robot can be shortened, and the tact time can be shortened.

### (Modification 3)

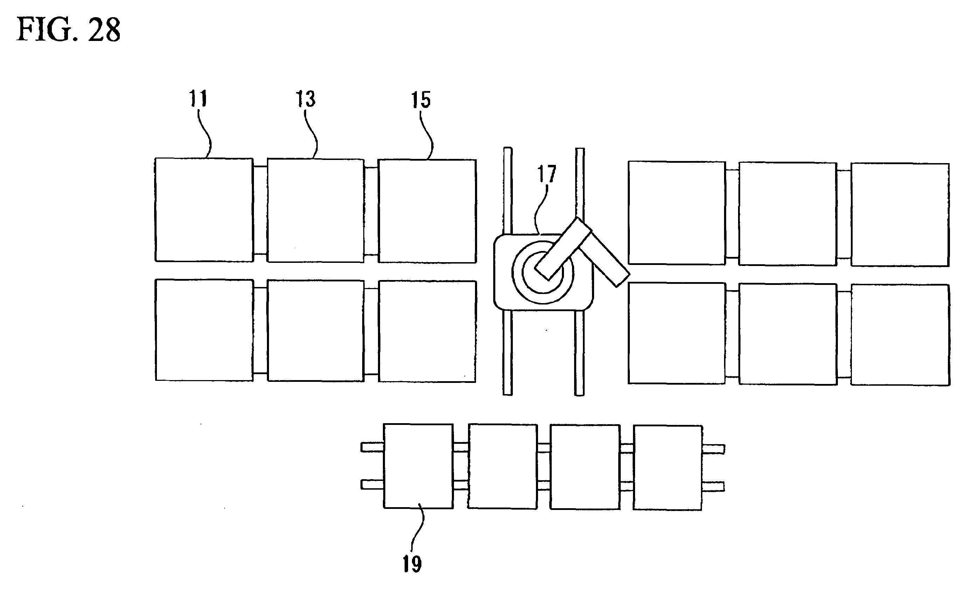

FIG. 28 is a schematic configuration view showing Modification 3 of the apparatus for manufacturing a thin-film solar cell.

As shown in FIG. 28, in the apparatus for manufacturing a thin-film solar cell, a module including a film forming chamber 11, a loading-ejecting chamber 13, and a substrate-replacement chamber 15 are installed on both sides of the substrate replacement robot 17, that is, on both sides of the substrate replacement robot 17 in a moving direction (direction in which the rails extends). In such a configuration, space can be saved, and the operating time of the substrate replacement robot can be shortened.

Although the present embodiment has a configuration in which one substrate replacement robot is arranged so as to perform attachment and detachment of a substrate, two substrate replacement robots may be adopted. In this case, one substrate replacement robot may be used exclusively for attachment of a substrate, and the other substrate replacement robot may be used exclusively for detachment of a substrate. Additionally, a substrate replacement robot configured so that two drive arms are provided in one substrate replacement robot, and two substrates are simultaneously attached and detached may be adopted.

### Industrial Applicability

As described above in detail, the present invention is useful for a film formation apparatus which is excellent in terms of productivity or manufacturing costs, and can realize a high throughput.

## Claims

1. A film formation apparatus comprising:
a film forming chamber in which a desired film is formed on a vacuum;
a loading-ejecting chamber fixed to the film forming chamber with a first opening-closing section interposed therebetween, being capable of reducing an internal pressure so as to form a vacuum atmosphere
a second opening-closing section provided at a face opposite to the face of the loading-ejecting chamber on which the first opening-closing section is provided; and
a carrier holding the substrate so that a film formation face of the substrate is substantially parallel to a direction of gravitational force, wherein
the carrier or the substrate passes through the second opening-closing section, and is transported to the loading-ejecting chamber and is transported from the loading-ejecting chamber; a plurality of carriers is disposed in the loading-ejecting chamber in parallel to each other; the plurality of carriers is transported in parallel between the loading-ejecting chamber and the film forming chamber; and a film is simultaneously formed on a plurality of substrates that is held by the plurality of carriers in the film forming chamber.

2. A film formation apparatus comprising:
a film forming chamber in which a desired film is formed on a substrate in a vacuum;
a loading-ejecting chamber fixed to the film forming chamber with a first opening-closing section interposed therebetween, being capable of reducing an internal pressure so as to form a vacuum atmosphere; and
a substrate-replacement chamber fixed to the loading-ejecting chamber with a second opening-closing section interposed therebetween, attaching the substrate to a carrier and detaching the substrate from the carrier, the carrier being capable of holding the substrate, wherein
the carrier holds the substrate so that a film formation face of the substrate is substantially parallel to a direction of gravitational force; a plurality of carriers is disposed in the substrate-replacement chamber in parallel to each other; the plurality of carriers is transported in parallel between the substrate-replacement chamber and the loading-ejecting chamber; the plurality of carriers is transported in parallel between the loading-ejecting chamber and the film forming chamber; and a film is simultaneously formed on a plurality of substrates that is held by the plurality of carriers in the film forming chamber.

3. The film formation apparatus according to claim 2, further comprising:
a plurality of process modules having a set of the substrate-replacement chamber, the loading-ejecting chamber, and the film forming chamber; and
a drive mechanism being common in a plurality of substrate-replacement chambers, and transporting the substrate to the substrate-replacement chambers or transporting the substrate from the substrate-replacement chambers.

4. The film formation apparatus according to claim 3, wherein
the process modules are arranged in parallel to each other; and
the drive mechanism has a moving section.

5. The film formation apparatus according to claim 3, wherein
the process modules are disposed so as to radially extend from the drive mechanism.

6. The film formation apparatus according to one of claims 1 and 2, further comprising:
a plurality of process modules in which one film forming chamber is consecutively connected to one loading-ejecting chamber, the process modules being disposed in parallel to each other.

7. The film formation apparatus according to one of claims 1 and 2, further comprising:
a process module in which each of a plurality of film forming chambers is consecutively connected to one loading-ejecting chamber, and in which the film forming chambers are disposed in parallel to each other.

8. The film formation apparatus according to one of claims 1 and 2, further comprising:
process modules in which one film forming chamber is consecutively connected to one loading-ejecting chamber; and
a drive mechanism transporting the substrate to the film forming chamber and transporting the substrate from the film forming chamber, wherein
the process modules are disposed so as to radially extend from the drive mechanism.

9. The film formation apparatus according to any one of claims 1 to 8, wherein
the carrier is capable of holding a plurality of substrates.

10. The film formation apparatus according to any one of claims 1 to 8, wherein
one or two carriers are capable of holding the substrate so that film formation faces of two substrates face each other.

11. The film formation apparatus according to any one of claims 1 to 10, further comprising:
a transfer section storing the substrate, and being capable of transferring the substrate outside of the film formation apparatus.

12. The film formation apparatus according to any one of claims 1 to 11, wherein
the film forming chamber has a film forming section that forms microcrystalline silicon on the substrate using a CVD method.

13. The film formation apparatus according to any one of claims 1 to 12, wherein
the loading-ejecting chamber is capable of simultaneously storing a first carrier in which a pre-transported substrate to be transported to the film forming chamber is held, and a second carrier in which a post-transported substrate that has been transported from the film forming chamber is held.

14. The film formation apparatus according to any one of claims 1 to 13, wherein
the film forming chamber has a plurality of electrode units, the electrode units including:
a cathode unit having cathodes to which a voltage is applied, the cathodes being disposed at both sides of the cathode unit; and
a pair of anode units having anode that separately face the cathodes disposed at both sides of the cathode unit, wherein,
the carrier is capable of holding the substrate so that the substrate faces the cathodes, and is capable of inserting the substrate between the cathodes and the anode.

15. The film formation apparatus according to claim 14, wherein
the electrode units are able to be drawn from the film forming chamber or able to be inserted to the film forming chamber.

16. The film formation apparatus according to one of claims 14 and 15, wherein
the electrode unit has a drive unit changing a distance between the cathodes and the anode.
